Europäisches Patentamt

European Patent Office

Office européen des brevets

(11) Numéro de publication: **0 207 860 B1**

## FASCICULE DE BREVET EUROPEEN

(45) Date de publication de fascicule du brevet:
**16.10.91**

(51) Int. Cl.5: **G01R 27/06, G01R 27/16**

(21) Numéro de dépôt: 86401426.1

(22) Date de dépôt: **27.06.86**

(54) **Procédé et dispositif pour le test rapide, par réflectométrie, dans les gammes VHF, de composants passifs.**

(30) Priorité: **01.07.85 FR 8510007**

(43) Date de publication de la demande:
**07.01.87 Bulletin 87/02**

(45) Mention de la délivrance du brevet:
**16.10.91 Bulletin 91/42**

(84) Etats contractants désignés:
**AT BE CH DE FR GB IT LI LU NL SE**

(56) Documents cités:
**FR-A- 2 514 902**

**HEWLETT PACKARD JOURNAL, vol. 31, no. 1, janvier 1980, pages 22-32, Palo Alto, California, US; T. ICHINO et al.: "Vector impedance analysis to 1000 MHz"**

**ELECTRONICS, vol. 32, no. 43, 23 octobre 1959, pages 120-121, New York, US; J. HANSON: "Unconventional technique for measuring VSWR"**

(73) Titulaire: **UNIVERSITE DE RENNES I
Campus de Beaulieu Avenue du Général Leclerc
F-35000 Rennes(FR)**

(72) Inventeur: **Le Traon, André
18, rue des Tilleuls
F-35510 Cesson-Sevigne(FR)**
Inventeur: **Haraoubia, Brahim
33, avenue des Buttes de Coemes Beaulieu
F-35042 Rennes Cédex(FR)**
Inventeur: **Pilet, Jean-Claude
27, Boulevard Charles Péguy
F-35000 Rennes(FR)**
Inventeur: **De Burgat, Michel
16, rue du Papier timbré
F-35000 Rennes(FR)**
Inventeur: **Meury, Jean-Loic
99, rue de la belle Epine
F-35510 Cesson-Sevigne(FR)**
Inventeur: **Le Traon, Flore
18, rue des Tilleuls
F-35510 Cesson-Sevigne(FR)**

TELECOMMUNICATIONS & RADIO ENGINEE-RING, vol. 35/36, no. 4, avril 1981, pages 103-105, Silver Spring, Maryland, US; L.I. BA-BAK: "A frequency method of measuring the scattering parameters of microwave four-poles"

MICROWAVE JOURNAL, vol. 10, no. 1, janvier 1967, pages 79-83, Dedham, US; "Complex impedance and gain measurement at RF and microwave frequencies"

J Osinga et al. Handbuch der elektronischen messgeräte (1984) franzis-Verlag Gmbh, München

(74) Mandataire: Martin, Jean-Jacques et al
Cabinet REGIMBEAU 26, Avenue Kléber
F-75116 Paris(FR)

## EP 0 207 860 B1

### Description

La présente invention concerne le test de dipôles passifs, en particulier de condensateurs.

Plus précisément, la présente invention concerne un procédé et un dispositif pour le test rapide, par réflectrométrie, dans les gammes V.H.F., de composants passifs.

Le document Handbuch der elektronischen Messgeräte, 1984, Franzis-Verlag GmbH, München, pages 262,263,266,267, décrit un dispositif formant réflectomètre qui comprend un générateur de signal électrique de fréquence variable dans la gamme V.H.F., une ligne connectée à une extrémité à un dipôle attesté formant impédance terminale, et par l'autre extrémité à un ensemble comprenant un premier coupleur directif et un deuxième coupleur directif conçus pour être intercalés entre le générateur et la ligne de sorte que le premier coupleur directif détecte un premier signal représentatif de l'onde réfléchie, et que le deuxième coupleur directif détecte un deuxième signal représentatif de l'onde incidente et des moyens de traitement comprenant des amplificateurs logarithmiques et un différenciateur pour former un signal de sortie représentatif du rapport entre le premier et le deuxième signal, ainsi qu'un écran de visualisation qui reçoit sur son entrée Y le signal de sortie précité et qui reçoit sur son entrée X un signal en dents de scie correspondant à la modulation en fréquence du générateur. Le réflectomètre comprend en outre un troisième coupleur directif conçu pour être connecté entre le dipôle à tester et une résistance terminale, sur une ligne auxiliaire de sortie, pour détecter un troisième signal représentatif de l'onde transmise par le dipôle à tester, ainsi que des moyens de traitement comprenant des amplificateurs logarithmiques et un deuxième différenciateur pour former un deuxième signal de sortie représentatif du rapport entre le troisième et le deuxième signal, ce deuxième signal de sortie pouvant être appliqué à l'entrée Y de l'écran de visualisation, à la place du premier signal de sortie.

Le document MICROWAVE JOURNAL, vol. 10, n° 1 (1967), pages 79 à 83, décrit un autre dispositif permettant de détecter différents signaux sur une ligne alimentée par un générateur en particulier de détecter l'onde totale et préconise d'exploiter ces signaux à l'aide d'une abaque de Smith.

Un premier but de la présente invention est de réaliser un dispositif de test rapide , dans la gamme V.H.F.,des dipôles passifs, à l'aide de moyens technologiques simples et selon un coût de revient très faible.

Un autre but de la présente invention est de permettre de déporter le dipôle sous test, à l'aide d'une ligne de transmission, par rapport à l'électronique de mesure,afin d'autoriser les tests de composants sous contraintes externes, telles que de fortes variations thermiques, par exemple en enceintes climatiques.

Un autre but de la présente invention est de permettre l'acquisition de l'ensemble des données couvrant la gamme de fréquences V.H.F., soit de l'ordre de 1 à 200MHz, en un temps très court de l'ordre d'une seconde.

Un autre but de la présente invention est de permettre d'automatiser aisément le processus de test .

Ces différents buts sont atteints selon la présente invention grâce à un procédé de test rapide , dans la gamme V.H.F., de dipôles passifs, comprenant les étapes consistant à :

i) connecter un générateur de signal électrique de fréquence située dans la game V.H.F. en tête d'une ligne et à connecter un dipôle à tester à l'autre extrémité de la ligne, sous forme d'impédance terminale,

ii) alimenter la ligne grâce au générateur par une onde incidente Vi périodique dont la fréquence est modulable dans la gamme V.H.F. pendant la durée du test,

iii) détecter au moins une tension sur la ligne pour définir l'évolution du coefficient de réflexion $\Gamma(\omega)$ sur la gamme V.H.F. et déterminer, à partir de ce coefficient de réflexion $\Gamma(\omega)$, l'impédance du dipôle à tester $Y(\omega)$, selon la relation

$$Y(\omega) = \frac{1}{R_c} \frac{1 - \Gamma(\omega)}{1 + \Gamma(\omega)}$$

dans laquelle Rc représente la résistance caractéristique de la ligne, caractéristé par le fait que:

- la ligne est constituée d'une ligne à constantes réparties de grande longueur par rapport aux longueurs d'ondes utilisées, soit de l'ordre de 100m, et
- l'étape iii) consiste à :
  * détecter en tête de ligne le tension totale Vt, représentative de la somme de l'onde réfléchie Vr et de l'onde incidente Vi,
  * détecter le module des maxima $Vt_M$ et des minima $Vt_m$ de la tension totale Vt et

* déterminer le module $|\Gamma|$ du coefficient de réflexion sur la base de la relation :

$$|\Gamma(\omega)| = \frac{|Vr|}{|Vi|} e^{2\alpha(\omega)l} = \frac{|Vt|_M - |Vt|_m}{|Vt|_M + |Vt|_m} e^{2\alpha(\omega)l}$$

dans laquelle

$\alpha$     représente l'atténuation de la ligne,

$l$     représente la longueur de la ligne, et

$\omega$     représente la pulsation.

Selon une caractéristique avantageuse de l'invention, à l'étape ii) la ligne est alimentée par une onde incidente $v_i$ périodique dont la période varie sur une gamme de l'ordre de 1 μseconde à 5ns sur une durée de test d'environ 1 seconde.

Selon l'invention, au cours de l'étape ii), la ligne est avantageusement alimentée par une onde incidente $v_i$ dont la période est modulée par vobulation sur la gamme V.H.F. selon une fonction linéaire ou logarithmique du temps.

Le procédé de test rapide conforme à la présente invention trouve notamment application dans l'analyse de condensateurs pour lesquels le module d'admittance $|Y|$ du dipôle évolue comme une suite de paliers de valeurs $G_j$, ceux-ci étant déterminés à l'étape iii sur la base de la relation :

$$G_j = \frac{1}{R_c} \frac{1 - |\Gamma_j|}{1 + |\Gamma_j|} \quad (1)$$

dans laquelle

$R_c$     représente l'impédance caractéristique de la ligne

      et

$|\Gamma_j|$     représente le module du coefficient de réflexion.

Plus précisément encore, le procédé de test rapide conforme à la présente invention permet l'analyse de condensateurs sous forme d'un réseau de n branches parallèles comportant chacune en série une résistance $R_j$ et une capacitance $C_j$, la résistance $R_j$ et la capacitance $C_j$ étant déterminées à l'étape iii) sur la base des relations :

$$\frac{1}{R_j} = G_j - G_{j-1} \quad (2)$$

dans laquelle

$G_j$ et $G_{j-1}$     représentent deux paliers successifs du module d'admittance $|Y|$,

et

$$C_j = \frac{G_j - G_{j-1}}{\omega_j} \quad (3)$$

dans laquelle

$\omega_j$     représente la pulsation critique de la branche considérée.

Selon une autre caractéristique avantageuse de la présente invention, l'étape ii) est réalisée à l'aide d'un oscillateur à fréquence variable à commutation automatique de bandes de fréquence intégré au générateur.

Selon une autre caractéristique avantageuse de l'invention, le circuit bouchon de l'oscillateur est associé à une diode varicap polarisée par un signal en dent de scie assurant la vobulation à l'intérieur de chaque bande de fréquence, le circuit bouchon de l'oscillateur comportant une pluralité de selfs progressivement mises an service pour assurer la commutation de bandes de fréquence.

Selon une caractéristique préférentielle de la présente invention, les signaux de commutation de bandes de fréquence assurant alternativement la mise en service des selfs du circuit bouchon de l'oscillateur sont générés à partir du signal en dent de scie polarisant la diode varicap. On obtient ainsi une synchronisation automatique entre la commutation de bandes de fréquence et la vobulation à l'intérieur de chacune des bandes.

Selon une autre caractéristique avantageuse de la présente invention, les signaux de commutation de bandes de fréquence sont générés en sortie d'un registre à décalage à entrée série et sorties parallèles commandé par le générateur de signal en dent de scie.

La présente invention concerne également un dispositif de test rapide dans la gamme V.H.F. de dipôles passifs comprenant :
- un générateur de signal électrique de fréquence variable dans la gamme V.H.F.,
- une ligne connectée en tête audit générateur, et en sortie au dipôle à tester formant impédance terminale,
- des moyens de détection d'au moins une tension sur la ligne pour définir l'évolution du coefficient de réflexion $\Gamma(\omega)$ sur la gamme V.H.F.,
- et des moyens aptes à déterminer, à partir de ce coefficient de réflexion $\Gamma(\omega)$, l'impédance du dipôle à tester $Y(\omega)$, selon la relation

$$Y(\omega) = \frac{1}{R_c} \frac{1 - \Gamma(\omega)}{1 + \Gamma(\omega)}$$

dans laquelle $R_c$ représente la résistance caractéristique de la ligne, caractérisé par le fait que
- la ligne est une ligne à constantes réparties de grande longueur, par rapport aux longueurs d'ondes utilisées, soit de l'ordre de 100m,
- les moyens de détection sont conçues pour détecter en tête de ligne, la tension totale Vt représentative de la somme de l'onde réfléchie Vr et de l'onde incidente Vi, et il est prévu :
- des moyens aptes à détecter le module des maxima $Vt_M$ et des minima $Vt_m$ de la tension totale Vt et
- des moyens aptes à déterminer le module $|\Gamma|$ du coefficient de réflexion sur la base de la relation :

$$|\Gamma(\omega)| = \frac{|Vr|}{|Vi|} e^{2\alpha(\omega)l} =$$
$$= \frac{|Vt|_M - |Vt|_m}{|Vt|_M + |Vt|_m} e^{2\alpha(\omega)l}$$

$\alpha$    représente l'atténuation de la ligne
$l$    représente la longueur de la ligne et
$\omega$    représente la pulsation.

D'autres caractéristiques et avantages de la présente invention apparaîtront à la lecture de la description détaillée qui va suivre, et en regard des dessins annexés, donnés à titre d'exemples non limitatifs et sur lesquels :
- la figure 1 illustre le principe général de test conforme à la présente invention,
- la figure 2 illustre la représentation sous forme d'un schéma standard équivalent de Foster d'un condensateur imparfait,
- la figure 3 représente le module $|Y_i| \cdot R_i$ d'admittance d'une branche du schéma précité,
- la figure 4 représente l'argument de l'admittance de la même branche du schéma,
- la figure 5 illustre schématiquement la structure du dispositif de test conforme à la présente invention par réflectométrie par ligne longue,
- la figure 6 représente une vue générale schématique, sous forme de blocs fonctionnels, du générateur utilisé dans le dispositif de test conforme à la présente invention,
- la figure 7 représente une vue schématique de l'oscillateur intégré au générateur précité,

- la figure 8 représente une vue du même oscillateur en combinaison avec un bloc de selfs à commuter, un générateur de signaux de commutation de bandes et un générateur de dents de scie polarisant une diode varicap associée à l'oscillateur pour assurer la vobulation à l'intérieur de chaque bande de fréquence,
- la figure 9 représente une vue schématique du générateur de dents de scie,
- la figure 10 illustre schématiquement la réalisation du générateur de dents de scie et du générateur de signaux de commutation de bandes synchronisés, conforme au mode de réalisation préférentiel de la présente invention,
- la figure 11 illustré un chronogramme de différents signaux représentatif du fonctionnement du générateur conforme à la présente invention.
- les figures 12 à 18 illustrent différents résultats de mesure conformes à la présente invention.
- la figure 19 illustre la structure d'un circuit de détection conçu pour la mise en oeuvre du procédé de test conforme à la présente invention,
- la figure 20 représente la structure d'un circuit de correction destiné à être utilisé avec le circuit de détection précité, et
- la figure 21 représente la structure d'un circuit de détermination de la phase de l'impédance connectée en bout de ligne.

## PRINCIPE GENERAL DU TEST CONFORME A LA PRESENTE INVENTION.

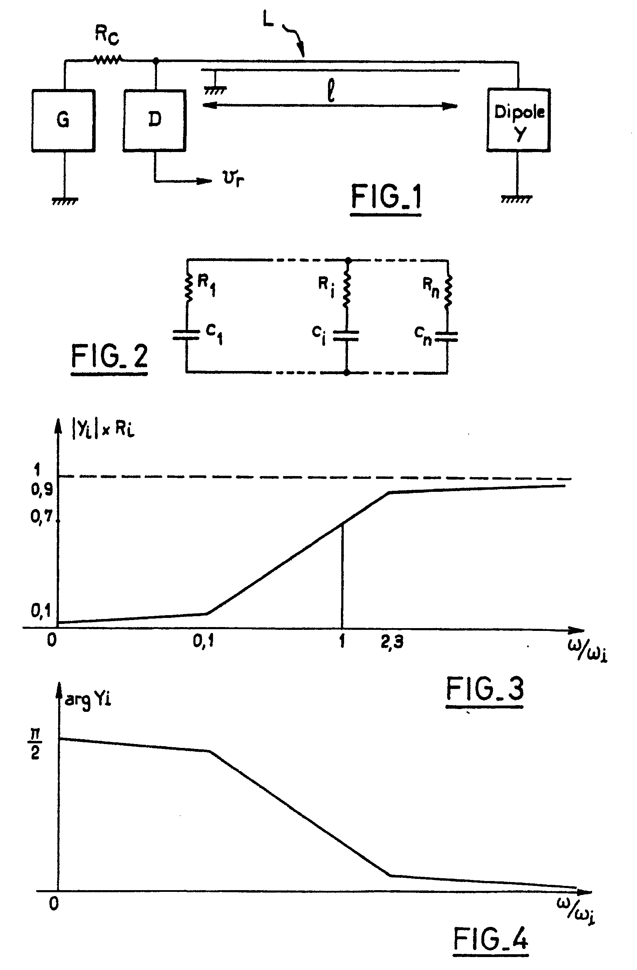

Comme cela est illustré schématiquement sur la figure 1, le processus de test conforme à la présente invention utilise un générateur G de signal électrique de fréquence variable dans la gamme V.H.F., connecté en tête d'une ligne à constantes réparties, en sortie de laquelle est relié le dipôle à tester, sous forme d'impédance terminale .

Le principe général du test consiste à alimenter la ligne L à constantes réparties, de longueur l, par une onde incidente $v_i$ périodique dont on fait varier la période, par exemple d'1 $\mu$seconde à 5ns pendant la durée très courte du test de l'ordre de 1 seconde, par vobulation selon une fonction linéaire ou logarithmique du temps, et à détecter en tête de la ligne l'onde $v_r$ réfléchie par le dipôle sous test inséré sous forme d'impédance terminale de la ligne.

Sur la figure 1, l'élément de détection de l'onde $v_r$ réfléchie par le dipôle est référencé schématiquement D.

L'ensemble comprenant le générateur G et l'élément de détection D, vu de l'entrée de la ligne L présente une impédance interne égale à l'impédance caractéristique $R_c$ (avantageusement $R_c$ = 50 ohms) de la ligne, pour réaliser l'adaptation en entrée de cette ligne.

Comme on l'a évoqué précédemment et comme cela sera décrit plus en détail par la suite, selon la présente invention, la séparation de l'onde incidente $V_i$ et de l'onde réfléchie $v_r$ est réalisée par réflectométrie sur ligne longue.

## ANALYSE GENERALE DES DIPOLES PASSIFS LINEAIRES.

Un dipôle passif linéaire est un réseau comportant deux pôles d'accès entre lesquels se dévellope un maillage de n branches. Chaque branche est constituée par la mise en série d'une résistance, d'une self inductance et d'une capacitance, l'un ou l'autre ou plusieurs de ces éléments pouvant être nul ou infini.

L'interaction du dipôle avec un circuit électrique dans lequel il est inséré est entièrement caractérisé par son admittance Y ou son impédance Z, abstraction faite de la structure réelle interne du réseau constituant le dipôle.

Le cas d'un dipôle constitué uniquement de deux types d'éléments : self inductance et capacitance, ou self inductance et résistance, ou capacitance et résistance, est justifiable du théorème de Foster. Dans un tel cas, le réseau réel constituant le dipôle peut à toutes fréquences être remplacé par un réseau standard dont le comportement externe lui est rigoureusement équivalent.

Pour un condensateur imparfait, c'est-à-dire présentant des pertes équivalent à des éléments purement résistifs, le schéma standard équivalent de Foster en admittance est illustré sur la figure 2.

Plus précisément, ce schéma standard comprend un réseau de n branches parallèles comportant chacune en série une résistance $R_i$ et une capacitance $C_i$.

L'admittance Y du dipôle s'exprime par la relation :

$$Y = \sum_{i=1}^{n} Y_i \quad (6) \text{ avec}$$

$$Y_i = \frac{j\, C_i\, \omega}{1 + j\, R_i\, C_i\, \omega} \quad (7)$$

On a représenté respectivement sur les figures 3 et 4, en fonction des ordonnées $\omega/\omega_i$, le module $|Y_i|$. $R_i$ du module d'admittance d'une branche du dipôle illustré sur la figure 2, d'une part, et l'argument de l'admittance $Y_i$ d'autre part.

Le comportement d'une branche, la $i^{\text{ème}}$, est caractérisé par la valeur de sa constante de temps $\tau_i = R_i C_i$ par rapport à la pulsation $\omega$.

Comme cela apparaît à l'examen des figures 3 et 4, pour une pulsation $\omega < 1/\tau_i$, la branche considérée présente une admittance capacitive tendant vers zéro lorsque $\omega$ décroit.

Par contre, pour une pulsation $\omega > 1/\tau_i$, la branche considérée présente une conductance limite tendant vers une asymptote constante $1/R_i$ lorsque $\omega$ croit.

Enfin, pour une pulsation $\omega \cong 1/\tau_i$, le comportement de la branche considérée présente une forte variation de l'admittance en module et en phase, comme cela apparaît respectivement sur les figures 3 et 4 annexées.

La zone de variation s'étend sur environ 1,5 décade de fréquence entourant la pulsation critique $\omega_i = 1/\tau_i$. En deça, la branche apporte une contribution voisine de zéro à l'admittance $Y$ totale et tend à se comporter comme un circuit ouvert. Au-delà, la branche ajoute une conductance $1/R_i$ à l'admittance globale.

Si deux ou plusieurs branches ont des pulsations critiques $\omega_i$ dans leur intervalle de 1,5 décade , et parconséquent se "recouvrent ", on montre qu'une représentation satisfaisante à quelques pour cent près, de leur contribution à l'admittance globale $Y$ peut être donnée par l'addition de deux branches $Y_a$ et $Y_b$ dont les caractéristiques $R_a C_a$ et $R_b C_b$ sont des valeurs moyennes des caractéristiques $R_i C_i$ des n branches concernées, soit :

$$\sum_{i=j}^{k} Y_i = Y_a + Y_b \quad (8)$$

Le relevé du module $|Y_i(\omega)|$ de l'admittance d'une branche de constante de temps $\tau_i$ sur une variation de pulsation couvrant 1,5 décade autour de la pulsation critique $\omega_i = 1/\tau_i$ permet de déterminer les paramètres caractéristiques $\tau_i$ et $1/R_i$ et par suite $C_i$.

De la même manière, le relevé du module de l'admittance $|Y(j\omega)|$ sur un intervalle de pulsation de 2,3 décades, permet la détermination des caractéristiques $R_a C_a$, $R_b C_b$, $R_d C_d$ d'un schéma à 3 branches suffisant pour décrire sur la gamme de fréquences considérée le comportement en module et en phase (ou conductance et susceptance) du dipôle sous test.

Le principe général de détermination des paramètres $R_i$ et $C_i$ a été évoqué dans la demande de brevet Française déposée au nom de la Demanderesse le 10.05.1984 sous le N. 84 07196 et publiée sous le N.2 564 205. On se reportera utilement à la description de cette demande de brevet pour la bonne compréhension de la présente invention.

PRINCIPE GENERAL D'OBTENTION DE L'ADMITTANCE DU DIPOLE PAR REFLECTOMETRIE.

On va dans un premier temps décrire les équations générales relatives à l'obtention de l'admittance du dipôle par réflectométrie.

Dans l'écriture de ces équations, on appellera :

$v_i$      la tension incidente appliquée sur la ligne L par le générateur G,

$v_r$      la tension réfléchie par le dipôle inséré sous forme d'impédance terminale, à l'entrée de la ligne,

l      la longueur de la ligne,

Y      l'admittance inconnue à tester,

$\Gamma$      le coefficient de réflexion dû au dipôle Y,

$R_c$      la résistance caractéristique de la ligne,

$\gamma = \alpha + j\beta$      la constante de propagation,

$\alpha(\omega)$      l'atténuation, fonction connue de la pulsation et pratiquement nulle pour une longueur de ligne faible,

$\beta = \frac{\omega}{v}$      la constante de phase,

$v$      la vitesse de propagation.

On obtient :

$$\Gamma = \frac{1-R_cY}{1+R_cY} \quad \text{d'où} \tag{9}$$

$$Y_{(j\omega)} = \frac{1}{R_c}\frac{1-\Gamma(\omega)}{1+\Gamma(\omega)} = \frac{1}{R_c}\frac{1-\frac{v_r}{v_i}e^{2\gamma l}}{1+\frac{v_r}{v_i}e^{2\gamma l}} \cdot \tag{10}$$

$$|\Gamma| = \left|\frac{v_r}{v_i}\right| e^{2\alpha(\omega)\,l} \quad \text{et} \tag{11}$$

$$\arg\Gamma = \arg\frac{v_r}{v_i} + \frac{2l}{v}\omega \tag{12}$$

D'autre part, la tension totale $v_t$ en entrée de ligne s'écrit

$$v_t = v_i + v_r = v_i(1 + \Gamma e^{-2\gamma l}) \tag{13}$$

On obtient par ailleurs

$$\cos\varphi = \frac{|v_t|^2 - (|v_i|^2 + |v_r|^2)}{2\,|v_i|\,|v_r|} \quad \text{(13 bis) en posant}$$

$$\varphi = \arg\frac{v_r}{v_i} \tag{13 ter}$$

## CAS DU CONDENSATEUR IMPARFAIT.

Dans le cas d'un condensateur, pour la pulsation $\omega$, les branches dont la pulsation critique $\omega_i$ est inférieure ou égale à $\omega/2,3$, se comportent comme des conductances $G_i = 1/R_i$ et la contribution de l'ensemble de ces branches 1 à j - 1 à l'admittance Y s'écrit :

$$G_j = \sum_{i=1}^{j-1}\frac{1}{R_i} \cdot \tag{14}$$

Par contre, les branches pour lesquelles la pulsation critique $\omega_i$ est supérieure à $10\omega$, ont un module d'admittance qui tend vers zéro et un argument vers $\frac{\pi}{2}$. Ces branches n'affectent pratiquement pas la valeur de $|Y|$ et ces branches se comportent comme des circuits ouverts. Le terme principal d'admittance est donc $G_j$ augmenté de la contribution des branches "actives" pour lesquelles la pulsation critique $\omega_i$ est voisine de $\omega$.

Lorsqu'on fait croître $\omega$, des branches successives du schéma de Foster passent d'un comportement de circuit ouvert à un comportement de conductivité $1/R_i$.

Le module d'admittance $|Y|$ évolue donc comme une suite de paliers de valeur $G_j$ séparés par des régions de forte variation correspondant à l'activité des branches j qui encadrent la pulsation :

$$\omega_j = \frac{1}{R_j C_j} \qquad (15)$$

Cette évolution est suivie par le coefficient de réflexion. En effet, aux valeurs $G_j$ évoluant par paliers correspondent des paliers

$$\Gamma_j = \frac{1 - R_c G_j}{1 + R_c G_j} \qquad (16)$$

où le coefficient de réflexion est purement réel, séparé par des régions de forte variation représentant "l'activité" de la branche j, pour lesquelles :

$$\Gamma_j(\omega) = \Gamma_j + \frac{\Gamma_{j-1} - \Gamma_j}{1 + jT_j \omega} \qquad (17)$$

avec

$$T_j = R_j C_j \qquad (18)$$

A la pulsation $\omega_j$ définie par la relation (15) correspond un module

$$|\Gamma_j(\omega_j)| = \frac{1}{2} \sqrt{\Gamma_j^2 + \Gamma_{j-1}^2} \qquad (19)$$

On obtient ainsi :

$$G_j = \frac{1}{R_c} \frac{1 - |\Gamma_j|}{1 + |\Gamma_j|} \qquad \text{puis} \qquad (1)$$

$$\frac{1}{R_j} = G_j - G_{j-1} \qquad (2)$$

et simultanément

$$C_j = \frac{G_j - G_{j-1}}{\omega_j} \qquad (3)$$

La procédure qui vient d'être décrite s'applique bien lorsque le rapport des constantes de temps $T_j/T_{j-1} \geqq 18$, c'est-à-dire lorsque les branches actives sont nettement séparées.

Un traitement un peu plus complexe est nécessaire dans le cas contraire, c'est-à-dire dans le cas où l'on constate un recouvrement des branches actives. Cependant, ce traitement ne fait intervenir que le module $|\Gamma|$.

Dans le cas d'un dipôle passif quelconque, il est nécessaire de connaître $|v_i|, |v_r|$ et $|v_t|$, et l'obtension des modules de ces trois tensions à une pulsation $\omega$ donnée suffit pour déterminer $Y(\omega)$.

La technique de mesure mise au point par les inventeurs utilise une ligne de grande longueur, par exemple $L = 100$ mètres et ne nécessite que la détection de la tension totale en entrée $v_t$, accompagnée du contrôle de la tension incidente $v_i$.

Cette technique de réflectométrie repose sur l'exploitation des équations suivantes dans lesquelles on a posé :

$$\varphi = \arg \frac{v_r}{v_i} \qquad (25)$$

$$\psi = \arg \Gamma \qquad (26)$$

$$v_t = v_i + v_r = v_i \left[ 1 + |\Gamma| \, e^{-2\alpha(\omega)\ell} \, e^{j\left(\psi - 2\frac{\ell}{v}\omega\right)} \right] \qquad (27)$$

Etant donné la valeur élevée du coefficient $2\ell/v$, due à la grande longueur de la ligne, la phase de l'onde réfléchie $v_r$ varie très vite avec la pulsation $\omega$.

Par contre, dans un premier temps, on peut admettre que les fonctions

$$|\Gamma(\omega)| e^{-2\alpha(\omega)\ell} \text{ et } \psi(\omega)$$

varient beaucoup plus lentement et restent pratiquement constantes pour une rotation de phase de $v_r$ de $2\pi$. Dans ces conditions, le module de l'onde réfléchie $|v_t|$ passe par un maximum pour les pulsations $\omega$ telles que

$$\varphi = \psi(\omega) - \frac{2\ell}{v}\omega = 2k\pi \qquad (28)$$

et par un minimum pour les pulsations tel que :

$$\varphi = \psi(\omega) - \frac{2\ell}{v}\omega = (2k + 1)\pi \qquad (29).$$

Les maximum s'écrivent :

$$\left| \frac{v_t}{v_i} \right|_M = 1 + |\Gamma(\omega)| e^{-2\alpha(\omega)\ell} \qquad (30)$$

Les minimum s'écrivent :

$$\left|\frac{v_t}{v_i}\right|_m = 1 - |\Gamma(\omega)| e^{-2\alpha(\omega)l} \qquad (31)$$

L'enveloppe des courbes

$$\left|\frac{v_t(\omega)}{v_i(\omega)}\right|_M - 1 \qquad (32)$$

ou

$$1 - \left|\frac{v_t(\omega)}{v_i(\omega)}\right|_m \qquad (33)$$

représente donc au coefficient connu $e^{-2\alpha(\omega)l}$ près la fonction $|\Gamma(\omega)|$. L'argument $\psi(\omega)$ s'obtient également pour tes extrémum $\omega_M$ et $\omega_m$ avec :

$$\psi_M(\omega_M) = 2k\pi + \frac{2l}{v}\omega_M \qquad (34)$$

$$\psi_m(\omega_m) = (2k+1)\pi + \frac{2l}{v}\omega_m \qquad (35)$$

Dans l'intervalle de ces pulsations, $\phi$ qui représente l'argument $v_r/v_i$ varie essentiellement par le terme linéaire $-2lv/\omega$ . Pour une pulsation $\omega_M + \Delta\omega$ comprise entre le maximum $|v_t|_M$ et le premier minimum qui le suit, $\phi$ prend la valeur :

$$\phi = \phi(\omega_M + \Delta\omega) = \psi(\omega_M + \Delta\omega) - \frac{2l}{v}\omega - \frac{2l}{v}\Delta\omega = 2k\pi - \frac{2l}{v}\Delta\omega \qquad (36).$$

On obtient alors :

$$\left|\frac{v_t}{v_i}\right| = \sqrt{1 + |\Gamma|e^{-4\alpha(\omega)l} + 2|\Gamma|e^{-2\alpha(\omega)l}\cos\psi} \qquad (37)$$

Avec une longueur de 100 mètres et une vitesse de propagation de $2.10^8$ m/seconde, le terme linéaire ($2l\Delta\omega/v$ )présent dans $\phi$ et dû à la ligne, fait varier la phase de $\pi$ pour une variation de fréquence de 0,5 MHz.

Un dipôle résonnant avec un coefficient de surtension élevé peut faire varier la phase de façon encore plus rapide mais dans un domaine étroit de pulsations. Cette pulsation de résonnance sera donc facilement repérée par une répartition anormale des phases $\phi$ relativement à la loi linéaire en $-2l\omega/v$

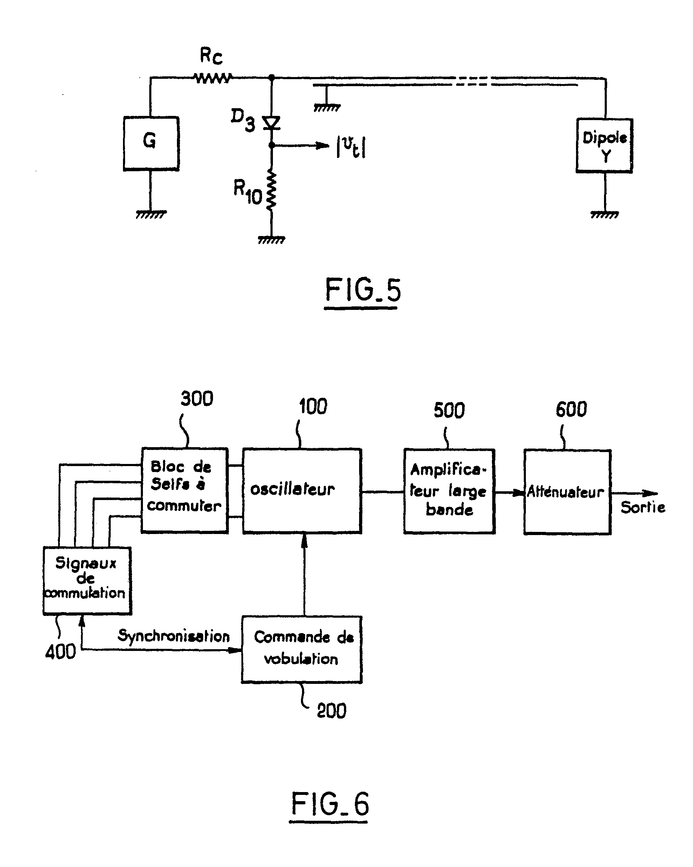

Le schéma du dispositif utilisé dans le cadre de cette technique de réfléctométrie par ligne longue est très simple, telle qu'illustrée sur la figure 5.

Il comprend en effet une simple branche de détection du module de la tension $v_t$ en tête de la ligne.

Cette branche de détection a été symbolisée sur la figure 5 par une diode $D_3$ dont l'anode est connectée à la ligne,en série d'une résistance $R_{10}$ connectée à la masse, le module $v_t$ étant prélevé au point médian de la branche de détection commun à la diode $D_3$ et à la résistance $R_{10}$. Les valeurs des extrémum du module $|v_t|$ très rapprochés sur l'axe les uns des autres, permettent d'obtenir les tensions $|v_i|$ et $|v_r|$ sur la base des relations :

$$|v_i| = \frac{|^v t|_M + |^v t|_m}{2} \qquad (38)$$

$$|v_r| = \frac{|^v t|_M - |^v t|_m}{2} \qquad (39)$$

## STRUCTURE DU GENERATEUR A COMMUTATION DE BANDE

Les inventeurs ont développé un oscillateur à fréquence variable sur la gamme V.H.F. (1 à 200 MHz), utilisant une commutation automatique rapide de bandes de fréquence, de réalisation simple et économique.

Le schéma général de ce générateur est illustré sur la figure 6.

Pour l'essentiel, ce générateur comprend un oscillateur 100 associé à des moyens 200 de commande de vobulation, et à un bloc de selfs 300 commutées alternativement par un générateur 400 de signaux de commutation synchronisés sur les moyens de commande de vobulation 200.

Par ailleurs, le générateur comprend un ampli large bande 500 connecté en sortie de l'oscillateur et qui attaque un atténuateur 600 dont la sortie constitue la sortie du générateur.

L'oscillateur 100 commandé en tension peut être à éléments intégrés ou discrets.

Le système de commutation de selfs 300-400 permet la couverture d'une assez large bande de fréquence.

La synchronisation des signaux de vobulation issus des moyens 200 et de commutation issus des moyens 400 permet d'assurer un balayage monotone de la bande de fréquence à couvrir.

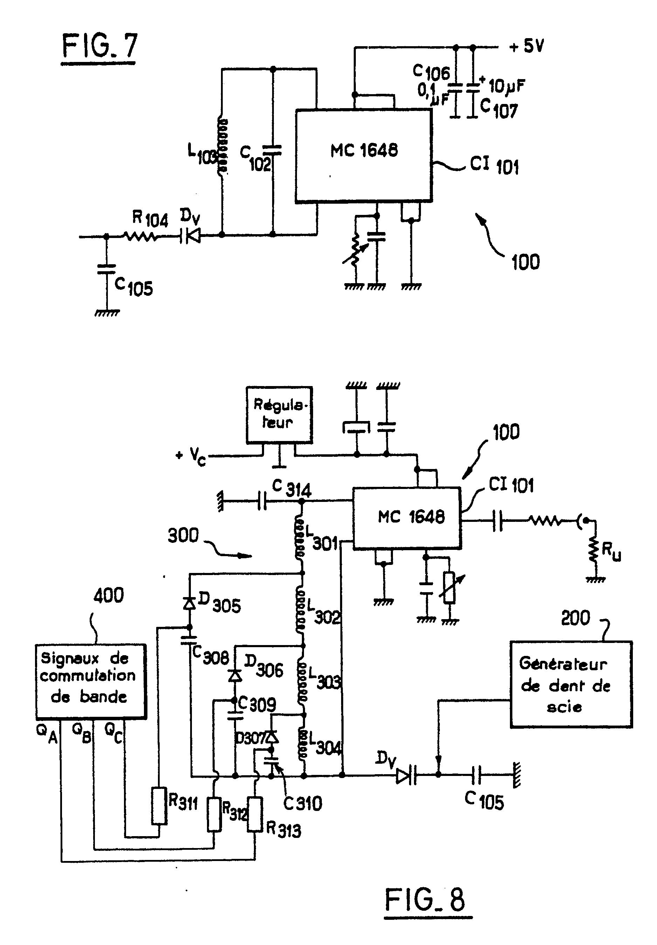

Un mode de réalisation avantageux de l'oscillateur 100 est illustré sur la figure 7.

Cet oscillateur 100 comprend un circuit intégré MC 1648.

Le circuit MC 1648 est un oscillateur en technologie E.C.L.

Il fonctionne avec un circuit bouchon externe formé selon l'illustration schématique de la figure 7 d'une cellule comprenant en parallèle une inductance L103 et une capacité C102 associées à une diode à capacité variable $D_v$.

Cette diode à capacité variable $D_v$ permet de transformer l'oscillateur en un oscillateur commandé par tension V.C.O.

Pour cela, l'anode de la diode à capacité variable $D_v$ étant reliée à l'un des pôles du circuit bouchon, la cathode de la diode à capacité variable est reliée à la masse du montage par l'intermédiaire d'une branche série comprenant une capacité $C_{105}$ côté masse et une résistance R104 côté cathode de la diode $D_v$.

Le point médian de la branche précitée commun à la capacité $C_{105}$ et la résistance R104 reçoit un signal variable de polarisation de la diode à capacité variable $D_v$ permettant de contrôler l'oscillateur.

L'alimentation du circuit est filtrée par des capacités C106, C107.

La bande de fréquence que peut couvrir le circuit MC 1648 est déduite de la relation suivante :

$$\frac{f_{max}}{f_{min}} = \frac{\sqrt{C_{Dmax} + C_s}}{\sqrt{C_{Dmin} + C_s}} \qquad (40)$$

avec

$$f = \frac{1}{2\pi \sqrt{L(C_D + C_s)}} \qquad (41)$$

dans lesquelles :

$$C_s = C_{ext} + C_{int} \, ,$$

$C_{ext}$ représente la capacité shunt externe,

$C_{int}$ représente la capacité shunt du circuit oscillateur (de l'ordre de 6pF),

$C_D$ représente la valeur de la capacité que présente la diode varicap pour une polarisation donnée.

Les signaux de sortie de l'oscillateur 100 sont de forme carrée. Leur excursion crête à crête et les fronts de montée sont déterminés par la tension de commande automatique interne.

Une connexion d'une résistance variable au point "contrôle automatique de gain" peut permettre d'obtenir une onde sinusoïdale en sortie.

Le circuit MC 1648 présente les caractéristiques suivantes :
- une tension d'alimentation unique ($+5$ V ou $-5,2$ V),
- une fréquence de répétition pouvant atteindre 200 MHz,
- une excursion de tension de sortie de 800 mV sur haute impédance,
- un rapport cyclique de 50%.

Comme on l'a évoqué précédemment, la couverture de la gamme V.H.F. 1MHz - 200 MHz est réalisée par commutation de selfs composant le circuit résonnant de l'oscillateur 100.

Cette disposition est illustrée sur la figure 8

Plus précisément, comme cela est illustré sur cette figure 8 , le circuit bouchon de l'oscillateur 100 est formé en combinaison de quatre selfs L301, L302, L303 et L304, associées à des capacités C308, C309, C310 et C314 et à une diode à capacité variable $D_v$.

Les quatre selfs L301, L302, L303 et L304 sont connectées en série.

La capacité C314 est connectée entre l'un des pôles du circuit bouchon et la masse.

La capacité C308 est connectée en parallèle des selfs L302, L303 et L304 par l'intermédiaire d'une diode $D_{305}$.

La capacité C309 est reliée en parallèle des selfs L303 et L304 par l'intermédiaire d'une diode $D_{306}$.

Enfin, la capacité C310 est reliée en parallèle de la self L304 par l'intermédiaire d'une diode $D_{307}$.

Plus précisément, la cathode de la diode $D_{305}$ est reliée au point commun aux selfs L301 et L302. La cathode de la diode $D_{306}$ est reliée au point commun à la self L302 et L303. Enfin, la cathode de la diode $D_{307}$est reliée au point commun à la self L303 et L304.

Le générateur de signaux de commutation de bande 400 attaque par sa sortie $Q_C$ et par l'intermédiaire d'une résistance R311 le point commun à l'anode de la diode $D_{305}$ et à la capacité C308. Le même générateur 400 de signaux de commutation de bande attaque par sa sortie $Q_B$ et par l'intermédiaire d'une résistance R312 le point commun à l'anode de la diode $D_{306}$ et à la capacité C309. Enfin, le générateur 400 de signaux de commutation de bande attaque par sa sortie $Q_A$ et par l'intermédiaire d'une résistance R313 le point commun à la diode $D_{307}$ et à la capacité C310.

Par ailleurs, comme cela est représenté sur la figure 8 , le générateur polarisant la diode varicap $D_v$ pour assurer la vobulation à l'intérieur de chaque bande de fréquence de l'oscillateur est avantageusement un générateur de dents de scie 200.

Le principe de commutation des selfs L301, L302, L303 et L304 est le suivant.

Au départ, le circuit oscillant est constitué par les quatre selfs L301, L302, L303 et L304 montées en série et la diode varicap $D_v$. Cette dernière est polarisée par un signal provenant du générateur de signaux en dents de scie 200 permettant ainsi la vobulation d'une première bande de fréquence $\Delta f_1$.

La validation de la sortie $Q_A$ du générateur 400 de signaux de commutation de bande cour-circuite la self L304 ce qui permet de réduire la self globale chargeant le circuit oscillant et ainsi d'augmenter sa fréquence de résonnance.

La dent de scie appliquée à l'anode de la diode à capacité variable $D_v$ assure la vobulation de la seconde plage de fréquences $\Delta f_2$.

De même, les selfs L303 et L302 sont successivement court-circuitées par la validation des sorties $Q_B$ et $Q_C$ du générateur 400 de signaux de commutation de bande pour obtenir des bandes supérieures $\Delta f_3$ et $\Delta f_4$ couvertes par la polarisation en dents de scie,issue du générateur 200,de la diode à capacité variable $D_v$.

Dans la pratique, on a constaté qu'il n'est pas nécessaire que les plages de fréquences $\Delta f_1$, $\Delta f_2$,$\Delta f_3$ et $\Delta f_4$ obtenues par commutation coïncident exactement. En d'autres termes, on peut tolérer un léger vide entre les domaines de fréquences $\Delta f_i$, ce qui permet de limiter le nombre de selfs à commuter.

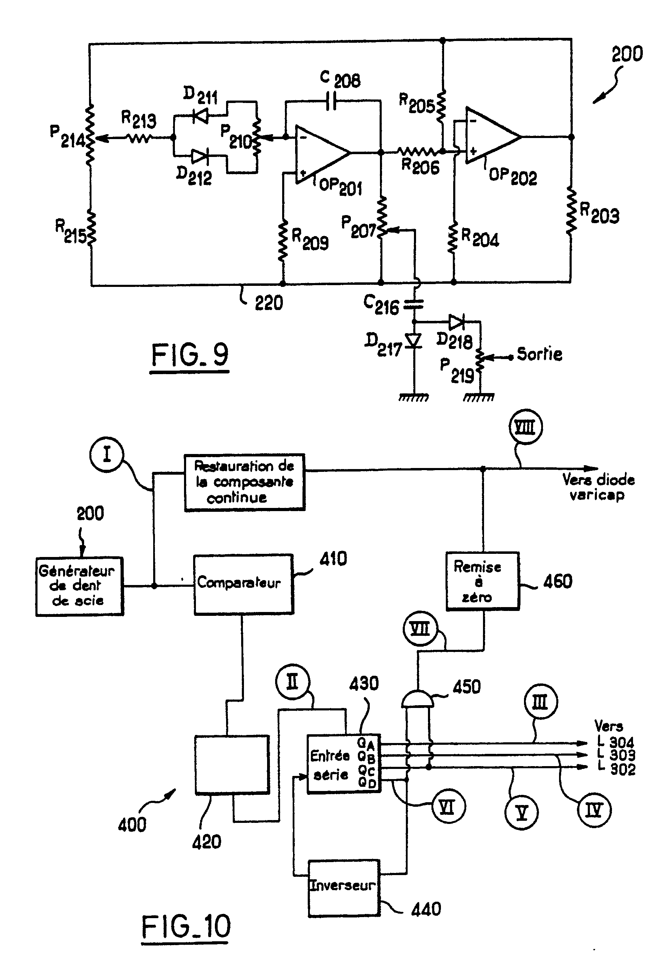

On a représenté sur la figure 9 la structure d'un générateur de dents de scie 200 susceptible d'être utilisé dans le cadre de la présente invention.

Ce générateur de dents de scie 200 est constitué par l'assemblage d'un intégrateur utilisant un amplificateur opérationnel OP201 et d'un comparateur utilisant un amplificateur opérationnel OP202.

La sortie de l'intégrateur constituée par la sortie de l'amplificateur opérationnel OP201 qui fournit une rampe linéaire sert de commande au comparateur , et pour cela est reliée par l'intermédiaire d'une résistance R206 à l'entrée non inverseuse de l'amplificateur opérationnel OP202.

Cette même entrée non inverseuse de l'amplificateur opérationnel OP202 est reliée à sa sortie par l'intermédiaire d'une résistance R205.

Par ailleurs, l'entrée inverseuse de l'amplificateur opérationnel OP202 est reliée à une ligne de base 220 par l'intermédiaire d'une résistance R204. La sortie de l'amplificateur opérationnel OP202 est également reliée à la ligne de base par l'intermédiaire d'une résistance R203.

Le signal obtenu en sortie de l'amplificateur opérationnel OP202 monté en comparateur et provenant de sa saturation haute et basse est envoyé à l'entrée de l'intégrateur.

Plus précisément, la sortie de l'amplificateur opérationnel OP202 est reliée à une première borne principale d'un potentiomètre P214 dont la seconde borne principale est reliée à la ligne de base 220 précitée par l'intermédiaire d'une résistance R215.

L'entrée inverseuse de l'amplificateur opérationnel OP201 est reliée au curseur d'un potentiomètre P210.

Les deux bornes principales du potentiomètre P210 sont reliées respectivement à l'anode d'une diode D211 et à la cathode d'une diode D212.

Par ailleurs, la cathode de la diode D211 et l'anode de la diode D212 sont reliées en commun à une première borne d'une résistance R213.

La seconde borne de la résistance R213 est reliée au curseur du potentiomètre P214 précité.

Une capacité C208 relie l'entrée inverseuse de l'amplificateur opérationnel OP201 à sa sortie.

L'entrée non inverseuse de l'amplificateur opérationnel OP201 est reliée à la ligne de base 220 précitée par l'intermédiaire d'une résistance R209.

La fréquence de récurrence du signal en dents de scie obtenue en sortie de l'intégrateur OP201 est déterminée par le condensateur C208 et le potentiomètre P214.

Le réglage du temps de retour est assuré par le système de diodes D211, D212 et le potentiomètre P210.

Le signal en dents de scie est prélevé au niveau d'un potentiomètre P207 connecté entre la sortie de l'amplificateur opérationnel OP201 et la ligne de base 220.

Plus précisément, le curseur du potentiomètre P207 est relié à la masse par l'intermédiaire d'une branche comprenant en série une capacité C216 côté curseur du potentiomètre P207 et une diode D217 dont l'anode est connectée à la masse.

Par ailleurs, une autre branche série comprenant une diode D218 et un potentiomètre P219 est connectée en parallèle de la diode D217.

L'anode de la diode D218 est reliée à la cathode de la diode D217 et la cathode de la diode D218 est reliée à la masse par l'intermédiaire du potentiomètre P219.

Le curseur de ce dernier constitue la sortie du générateur de dents de scie 200 attaquant la diode à capacité variable $D_v$ pour polariser celle-ci.

Les diodes D217, D218 et le condensateur C216 permettent de restituer la composante continue, le signal de sortie étant à polarité positive.

Selon une caractéristique importante de la présente invention, pour arriver à un synchronisation parfaite entre la commutation des selfs L302, L303 et L304 et la commande de vobulation issue du générateur de dents de scie 200, ce dernier est utilisé comme pilote pour générer les signaux de commutation.

Comme illustré sur la figure 10, un comparateur 410 de seuil nul est excité par les ondes en forme de dents de scie issues du générateur 200, et génère à sa sortie les signaux relatifs à la saturation haute et basse.

Un étage tampon 420 connecté en sortie du comparateur 410 adapte ses états au niveau de la logique TTL et génère en sortie un signal d'horloge assurant le séquencement de la commutation des selfs L302, L303 et L304.

Pour cela, le signal d'horloge issu de l'étage tampon 420 attaque un registre à décalage 430, à entrée série et à sorties parallèles.

Les trois premières sorties $Q_A$, $Q_B$ et $Q_C$ du registre à décalage 400 assurent la commutation des selfs L302, L303 et L304, comme indiqué précédemment en regard de la figure 10.

La quatrième sortie $Q_D$ du registre à décalage 430 rebouclée sur une entrée de commande de celui-ci par l'intermédiaire d'un inverseur 440 permet de contrôler le déroulement recherché du cycle de commutation.

Par ailleurs, les sorties $Q_D$ et $Q_C$ du registre à décalage 430 assurent la remise à zéro du système de vobulation.

Pour cela, les sorties $Q_D$ et $Q_C$ sont reliées respectivement aux entrées d'une porte ET 450 qui attaquent une cellule de remise à zéro 460 reliée à la diode à capacité variable $D_v$.

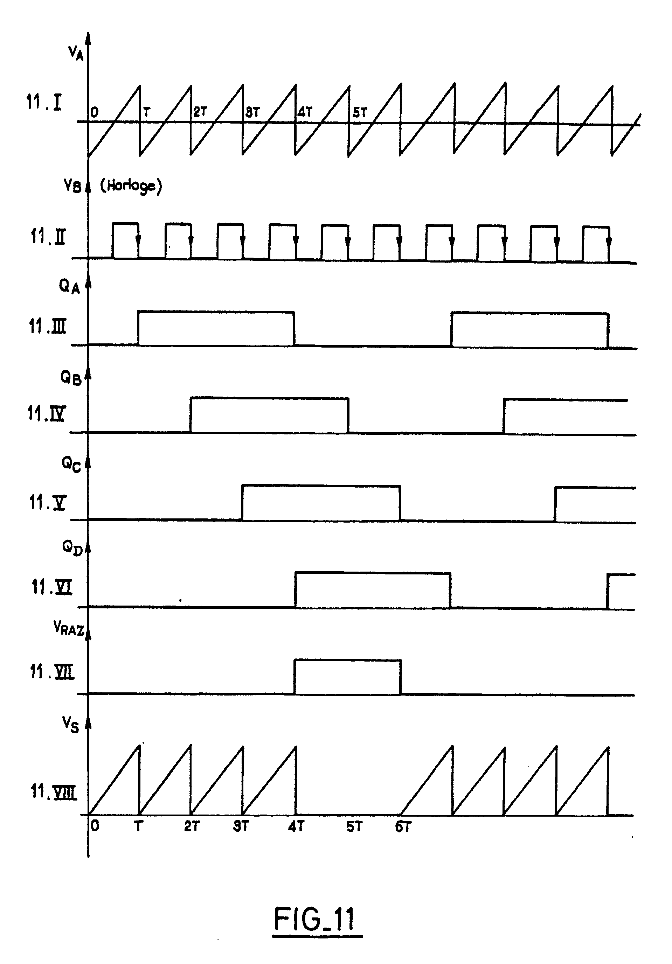

L'homme de l'art comprendra aisément le fonctionnement du générateur qui vient d'être décrit en regard du chronogramme illustré sur la figure 11.

La première ligne 11.I de la figure 11 illustre le signal en dents de scie issu du générateur 200.

La seconde ligne 11.II de la figure 11 illustre le signal d'horloge appliqué au registre à décalage 430.

Les troisième, quatrième, cinquième et sixième lignes 11.III, 11.IV, 11.V et 11.VI de la figure 11 illustrent respectivement les sorties $Q_A$, $Q_B$, $Q_C$ et $Q_D$ du registre à décalage 430.

La septième ligne 11.VII de la figure 11 illustre le signal de remise à zéro issu de la porte ET 450.

Enfin, la huitième ligne 11.VIII de la figure 11 illustre le signal de polarisation appliqué sur la diode à capacité variable $D_v$.

On comprend à l'examen de la figure 11 que :

- pour $0 < t < T$, toutes les selfs L301, L302, L303 et L304 sont actives et la dent de scie de durée T issue du générateur 200 permet d'obtenir un signal dont la fréquence couvre une plage $\Delta f_1$ due à la polarisation variable de la diode $D_v$.
- Pour $T < t < 2T$, la sortie $Q_A$ du registre à décalage 430 est à l'état haut , ce qui polarise la diode D307 dans le sens direct et permet de court-circuiter la self L304. Le circuit oscillant n'est plus formé que des selfs L301, L302, L303 et de la diode varicap $D_v$. On a ainsi assuré une commutation de fréquence dans la plage supérieure $\Delta f_2$. Là encore, la dent de scie de durée T polarisant la diode $D_v$ permet de couvrir la plage de fréquences $\Delta f_2$.
- Pour $2T < t < 3T$, la sortie $Q_B$ du registre à décalage 430 est à l'état haut ce qui permet de polariser la diode D306 dans le sens direct et de court-circuiter la self L303. Le circuit oscillant n'est alors formé que des selfs L301, L302 et de la diode à capacité variable $D_v$ pour obtenir un décalage dans le domaine de fréquence $\Delta f_3$ couvert par la polarisation variable de la diode $D_v$ du signal en dents de scie de période T.
- Pour $3T < t < 4T$, la diode D305 est polarisée dans le sens direct par les passages à l'état haut de la sortie $Q_C$ du registre à décalage ainsi, seules la self L301 et la diode à capacité variable $D_v$ forment le circuit résonant pour obtenir une commutation dans le domaine de fréquence supérieur $\Delta f_4$ couvert par la diode varicap $D_v$.

On a ainsi obtenu une couverture totale de la bande de fréquence désirée.

Une réinitialisation doit être effectuée automatiquement à la fin du cycle.Pour cela, on bloque l'envoi de signaux sur la diode varicap $D_v$ par une remise à zéro du signal de commande de cette dernière grâce à la porte ET 450 et à la cellule 460 précitées.

## UTILISATION DES RESULTATS DE MESURE POUR L'ANALYSE DES DIPOLES.

Deux cas doivent être considérés.

Dans le premier cas, on mesure directement $|v_t|$, et des extremums très serrés de $|v_t(\omega)|$ on peut tirer $|v_t(\omega)|$ et $|v_r(\omega)|$ sur la base des relations (38) et (39).

On dispose ainsi directement du module $|v_r/v_i|$et, après calcul, de l'argument $\phi$ de $v_r/v_i$ obtenu grâce à la relation (13bis).

$Y(j\omega)$ est ensuite déterminé par la relation (10). Son obtention ne nécessite aucune hypothèse de départ sur la structure interne du dipôle.

Dans le second cas, on maintient $|v_i(\omega)|$ et on mesure uniquement $|v_t(\omega)|$ (à l'aide de la ligne longue) dont on déduit $|v_r(\omega)|$. Dans ce cas, il faut faire la mesure sur une gamme étendue de pulsations et disposer d'un modèle paramétrique (schéma de Foster d'un condensateur imparfait) dont on détermine les paramètres.

## CAS DU RECOUVREMENT DES BRANCHES ACTIVES DU DIPOLE

Dans l'expression :

$$\Gamma(j\omega) = j + \frac{\Gamma_{j-1} - \Gamma_j}{1 + j\tau_j\omega} \qquad (17)$$

$\Gamma_{j-1}$ prend en compte toutes les contributions, devenues purement réelles, des branches qui ont été activées lors d'un balayage à pulsation $\omega$ croissante avant d'atteindre la pulsation

$$\bar{\omega}_j = \frac{1}{\bar{T}_j}$$

et $\Gamma_j$ est la valeur réelle qu'atteindra $\Gamma(j\omega)$ lorsque $\omega$ dépassant $\omega_j$ la branche j cessera d'être active.
L'expression ;

$$G_{(j\omega)} = \frac{\Gamma_{j-1} - \Gamma_j}{1 + j\, T_j\, \omega} \qquad (42)$$

peut donc être considérée comme l'expression du domaine de variation de la branche j. L'"amplitude" Aj de ce domaine est la quantité $\Gamma_{j-1} - \Gamma_j$, on peut écrire

$$|G| = \frac{A_j}{1 + T_j^2 \omega^2} = \frac{A_j}{1 + \dfrac{\omega^2}{\omega_j^2}} \qquad (43)$$

On peut définir le domaine fréquentiel de variation de la branche j par l'intervalle $\omega_{Bj}$, $\omega_{Hj}$ avec

$$(44) \qquad |G| = A_j\,(1-0{,}1)$$

pour $\omega_{Bj}$ ce qui donne

$$(45) \qquad \omega_{Bj} = \frac{1}{\sqrt{10}}\; \bar{\omega}_j \qquad et$$

$$(46) \qquad |G| = A_j \times 0{,}1 \qquad pour\; \omega_{Hj} \quad soit$$

$$(47) \qquad \omega_{Hj} = \sqrt{10}\; \bar{\omega}_j$$

On obtient donc

$$\frac{\omega_{Hj}}{\omega_{Bj}} = 10$$

Le domaine de variation d'une branche j s'étend donc sur une décade de fréquence. En dehors de cet intervalle, le module de G diffère de moins de 10% de ses valeurs asymptotiques.

Cet intervalle vaut toujours une décade et est indépendant de l'amplitude $A_j$.

Dès lors, si l'intervalle fréquentiel mesuré entre 2 paliers successifs de la courbe $|\Gamma(\omega)|$ à partir des repères à 10% de l'amplitude $A_j$ séparant les paliers, est supérieur à 1 décade, c'est qu'il y a recouvrement de branches actives.

$A_j$ peut alors être considéré comme la somme des amplitudes $A_1$, $A_2$... des branches actives en recouvrement, mais le recouvrement a pour effet de réduire l'intervalle fréquentiel qui, pour deux branches par exemple, sera compris entre 1 décade et 2 décades.

L'expression du coefficient de réflexion devient :

$$(48) \quad \Gamma(\omega) = \Gamma + \frac{A_1}{1 + jT_1\omega} + \frac{A_2}{1 + jT_2\omega} \quad \text{avec :}$$

$$T_1 = \frac{1}{\omega_1} \qquad T_2 = \frac{1}{\omega_2} \quad ; \quad \omega_1 < \omega_2 < 10\omega_1$$

Les deux domaines présentent donc une zone où ils sont "actifs" simultanément. Cependant, à pulsation croissante le domaine $A_1$ est le premier actif et, pour les pulsations $\omega$ faibles proches du début du domaine global de variation, on peut écrire :

$$\Gamma(\omega) = \Gamma + A_2 + \frac{A_1}{1 + T_1^2\omega^2} - \frac{j A_1 T_1 \omega}{1 + T_1^2 \omega^2} \qquad (49)$$

ou encore, avec $T_1\omega \ll 1$ :

$$\Gamma(\omega) = \Gamma + A_2 + A_1 - A_1 T_1^2 \omega^2 - j A_1 T_1 \omega \quad (50) \quad \text{soit}$$

$$|\Gamma(\omega)| = \left[ (\Gamma + A_2 + A_1)^2 \left( 1 - \frac{2A_1 T_1^2 \omega^2}{\Gamma + A_2 + A_1} \right) + A_1^2 T_1^2 \omega^2 \right]^{1/2} \qquad (51)$$

ou

$$|\Gamma(\omega)| = (\Gamma + A_2 + A_1)\left( 1 - \left[ \frac{A_1}{\Gamma + A_2 + A_1} - \frac{A^2}{2(\Gamma + A_2 + A_1)^2} \right] T_1^2 \omega^2 \right) \qquad (52)$$

qu'on peut écrire

$$\log|\Gamma(\omega)| = \log(\Gamma + A_2 + A_1) - \left[ \frac{A_1}{\Gamma + A_2 + A_1} - \frac{1}{2} \frac{A_1^2}{(\Gamma + A_2 + A_1)^2} \right] \frac{\omega^2}{\omega_1^2} \qquad (53)$$

relation linéaire entre $\log|\Gamma(\omega)|$ et $\omega^2$.

La pente de cette droite s'écrit

$$P_1 = -\left[ \frac{A_1}{\Gamma + A_2 + A_1} \left( 1 - \frac{1}{2} \frac{A_1}{\Gamma + A_2 + A_1} \right) \right] \frac{1}{\omega_1^2} \qquad (54)$$

De même, pour les pulsations $\omega$ élevées proches de la fin du domaine de variation global, seul le domaine 2 reste actif mais son comportement se réduit à un terme

$$\frac{A_2}{jT_2\omega}$$

on peut encore écrire

$$\Gamma(\omega) = \Gamma + \frac{A_2}{jT_2\omega} = \Gamma - j\frac{A_2}{T_2}\omega \qquad (55)$$

et

$$|\Gamma(\omega)| = \Gamma\left(1 + \frac{A_2^2}{2\Gamma^2 T_2^2\omega^2}\right) \qquad (56) \qquad \text{d'où}$$

$$\log|\Gamma(\omega)| = \log\Gamma + \frac{A_2^2\,\omega_2^2}{2\Gamma^2}\times\frac{1}{\omega^2} \qquad (57) \text{ d'où une pente}$$

$$P_2 = \frac{A_2^2\,\omega_2^2}{2\Gamma_2^2} \qquad (58) \text{ pour la droite } \log|\Gamma(\omega)| = f\left(\frac{1}{\omega^2}\right)$$

Enfin, dans la région central, pour $\omega_1 <\omega< \omega_e$ ; on est relativement proche pour les deux domaines, des conditions

$$\frac{\omega}{\omega_1} = 1 \qquad \text{et} \qquad \frac{\omega}{\omega_2} = 1.$$

Posons, pour le premier domaine $\omega = \omega_1 + x$, soit $x = \omega - \omega_1$ avec $x \ll \omega_1$, on obtient :

$$\frac{A_1}{1+jT_1\,\omega} = \frac{A_1}{1+j\frac{\omega}{\omega_1}} = \frac{A_1}{1+j+j\frac{x}{\omega_1}} = \frac{A_1\left[1-j\left(1+\frac{x}{\omega_1}\right)\right]}{2\left(1+\frac{x}{\omega_1}\right)} \qquad (59)$$

$$\frac{A_1}{1+j\frac{\omega}{\omega_1}} = \frac{A_1}{2}\left[\frac{1}{1+\frac{x}{\omega_1}}-j\right] = \frac{A_1}{2}\left[\frac{\omega_1}{\omega}-j\right] \qquad (60)$$

Si on suit la même procédure pour le domaine 2, on trouve :

$$\frac{A_2}{1+j\frac{\omega}{\omega_2}} \approx \frac{A_2}{2}\left[\frac{\omega_2}{\omega} - j\right] \quad (61) \quad d'où$$

$$|\Gamma(\omega)| = \left[\left(\Gamma + \frac{A_1\omega_1 + A_2\omega_2}{2\omega}\right)^2 + \left(\frac{A_1 + A_2}{2}\right)^2\right]^{1/2} \quad (62)$$

$$= \left(\frac{A_1 + A_2}{2}\right)\left[1 + \left(\frac{2\Gamma}{A_1 + A_2} + \frac{A_1\omega_1 + A_2\omega_2}{A_1 + A_2} \times \frac{1}{\omega}\right)^2\right]^{1/2}$$

Posons

$$(63) \quad \omega_M = \frac{A_1\omega_1 + A_2\omega_2}{A_1 + A_2}$$

on obtient :

$$|\Gamma(\omega_M)| = \left[\left(\frac{A_1 + A_2}{2}\right)^2 + \left(\Gamma + \frac{A_1 + A_2}{2}\right)^2\right]^{1/2}.$$

Sur la courbe $|\Gamma(\omega)|$ on cherche la valeur $|\Gamma(\omega_M)|$ qu'on détermine par la formule ci-dessus dans laquelle $\Gamma$ est connu ainsi que $A_1 + A_2 = A$ amplitude du domaine global. La pulsation $\omega_M$ correspondant à la valeur définie ci-dessous, on dispose, à présent pour déterminer $A$, $A_2$, $\omega_1$ $\omega_2$ de quatre équations :

$$A_1 + A_2 = A \quad (65)$$

$$A_1 \omega_1 + A_2 \omega_2 = A\omega_M \quad (66)$$

$$P_1 = -\left[\frac{A_1}{\Gamma + A_2 + A_1}\left(1 - \frac{1}{2}\frac{A_1}{\Gamma + A_2 + A_1}\right)\right]\frac{1}{\omega_1^2} \quad (54)$$

$$P_2 = \frac{A_2^2 \omega_2^2}{2\Gamma^2} \quad (58)$$

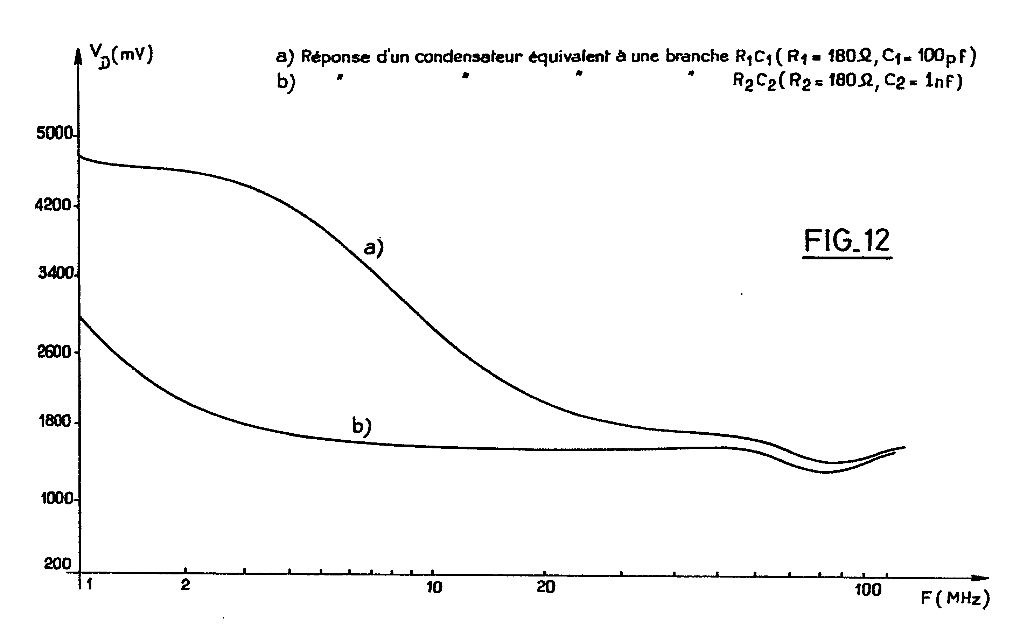

La figure 12 montre en courbe a) la réponse d'un condensateur équivalent à une branche $R_1 C_1$ avec $R_1 = 180\Omega$ et $C_1 = 100$ pf et en courbe b)la réponse d'un condensateur équivalent à une branche $R_2 C_2$ avec $R_2 = 180\Omega$, $C_2 = 1$nf .

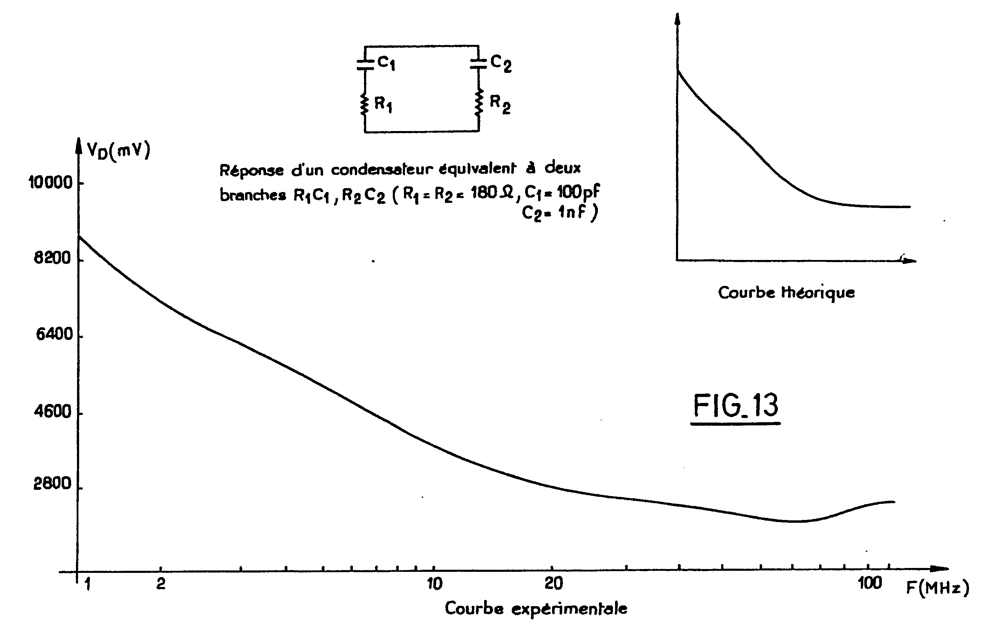

La figure 13 représente d'une part la courbe expérimentale, d'autre part la courbe théorique de la réponse d'un condensateur équivalent à deux branches $R_1 C_1$, $R_2 C_2$ avec $R_1 = R_2 = 180\Omega$, $C_1 = 100$pf, $C_2 = 1$nf .

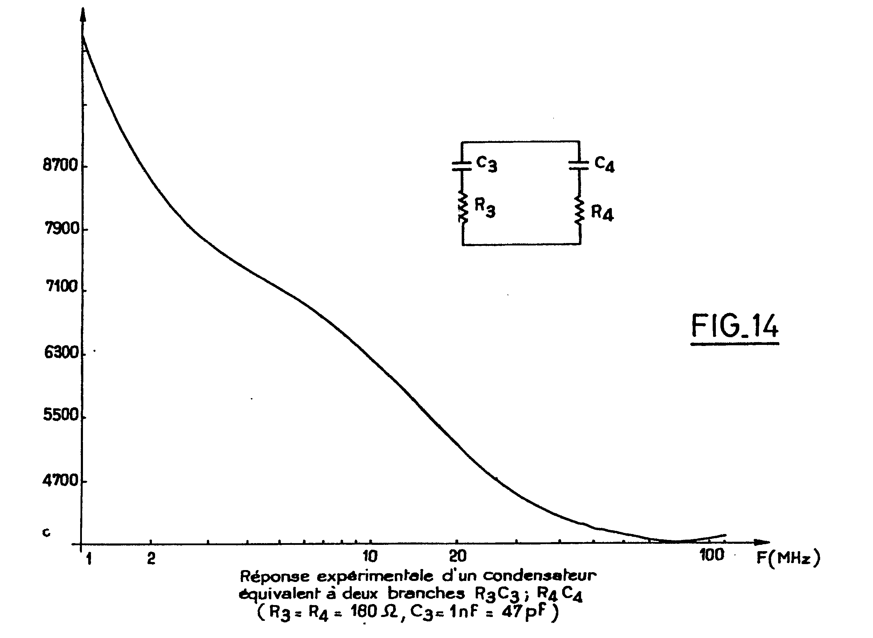

La figure 14 représente la réponse expérimentale d'un condensateur équivalent à deux branches $R_3 C_3$, $R_4 C_4$ avec $R_3 = R_4 = 180\Omega$, $C_3 = 1$nf, $C_4 = 47$ pf .

Sur les figures 12 , 13 , 14 $V_D$ représente la tension réfléchie détectée.

On a donc $V_D$ proportionnel à $|v_r|$ et proportionnel $|\Gamma(\omega)|$.

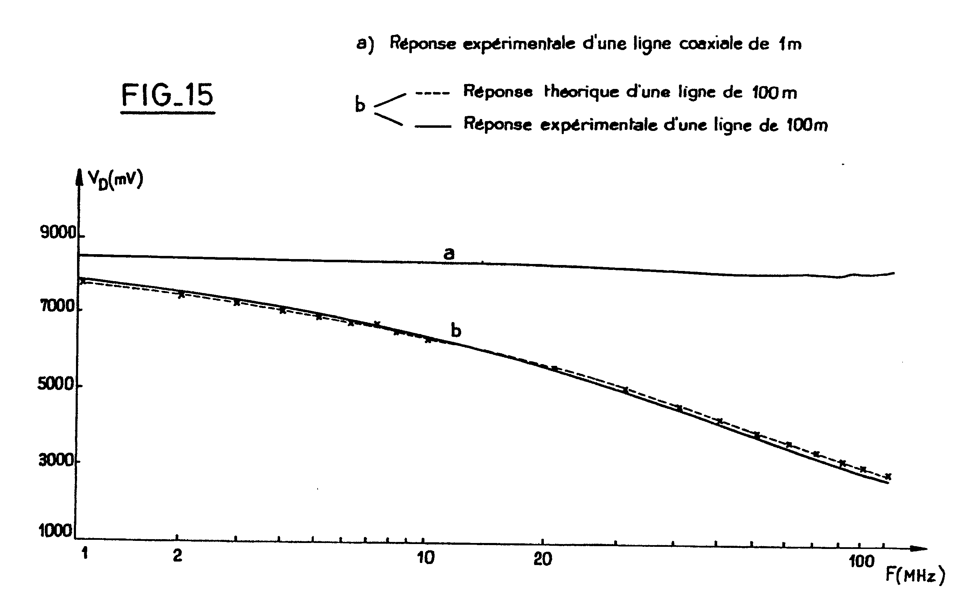

La figure 15 montre en courbe a)la réponse expérimentale d'une ligne coaxiale de 1 m, en courbe b) tiretée, la réponse théorique d'une ligne de 100 m et en courbe b) continue, la réponse expérimentale d'une ligne de 100 m.

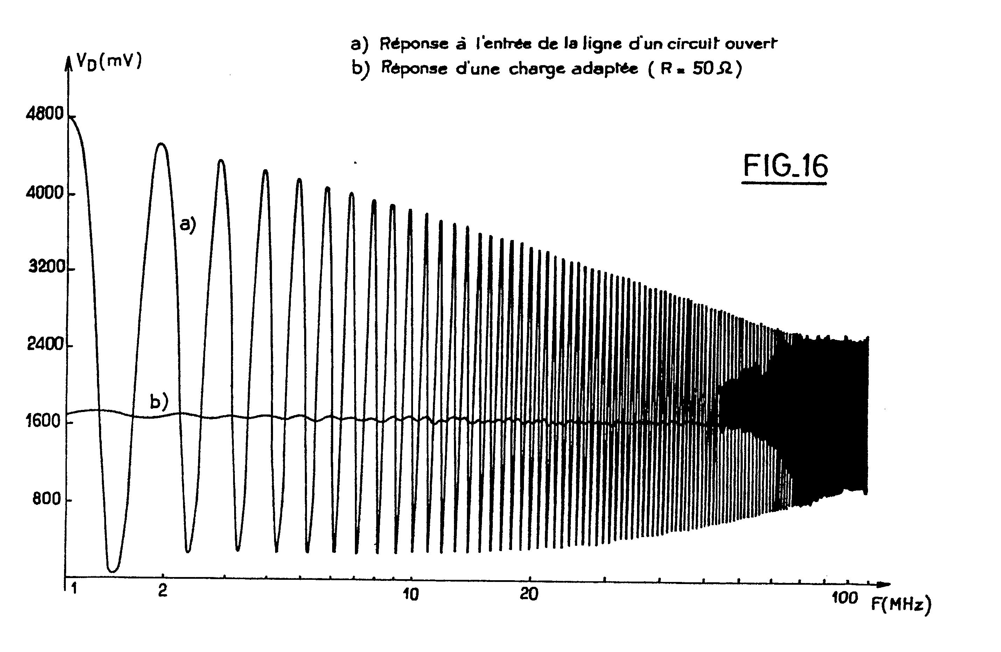

La figure 16 montre en courbe a) la réponse à l'entrée de la ligne d'un circuit ouvert et en courbe b) la réponse d'une charge adaptée (R = 50 Ω).

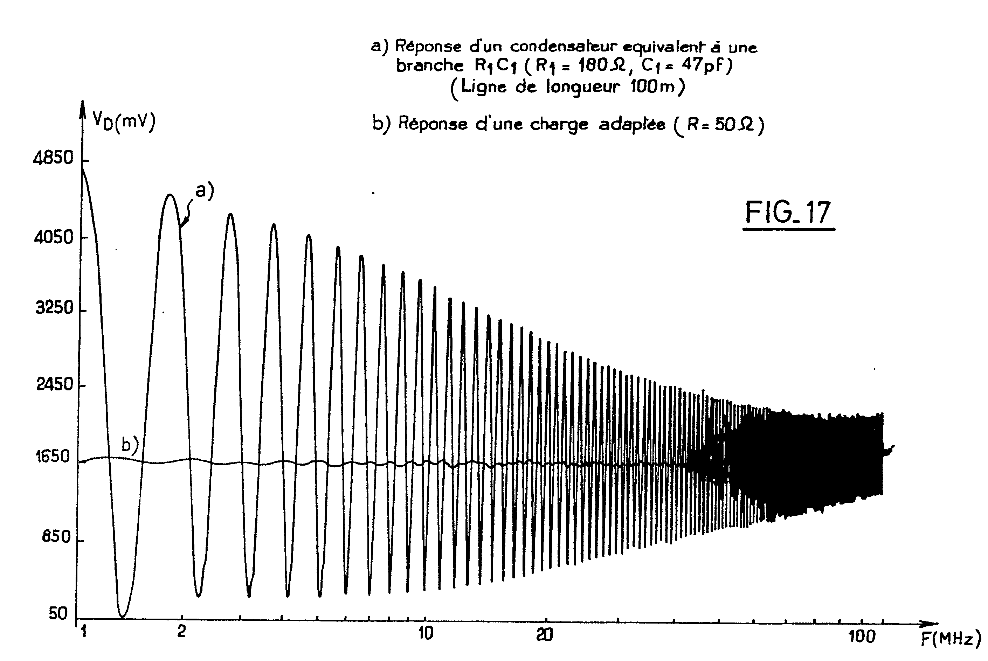

La figure 17 montre en courbe a) la réponse d'un condensateur équivalent à une branche $R_1 C_1$ avec $R_1$ = 180Ω , $C_1$ = 47 pf (ligne de longueur 100 m) et en courbe b) la réponse d'une charge adaptée avec R = 50Ω .

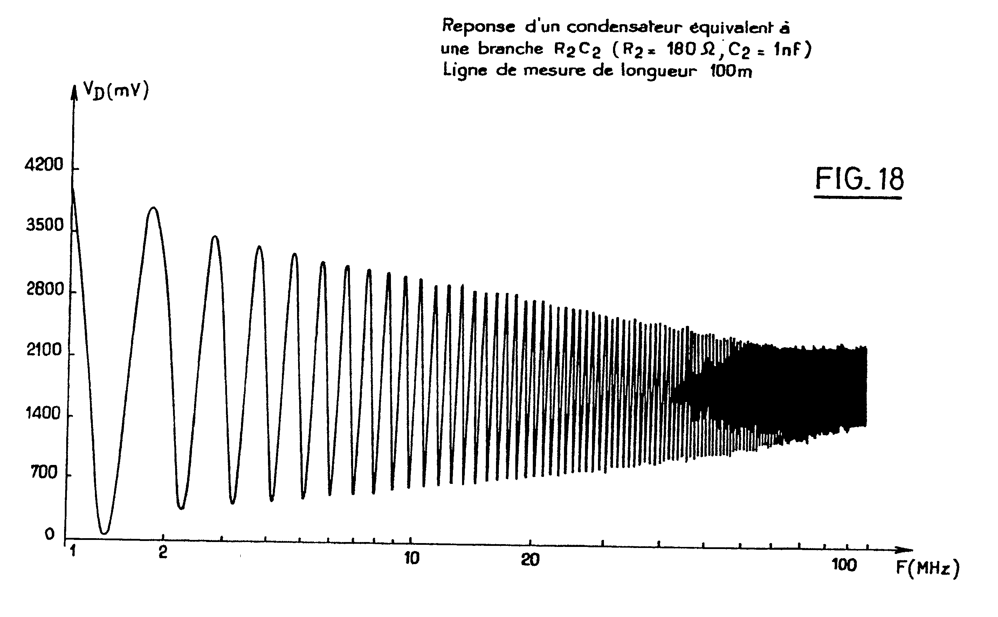

La figure 18 montre la réponse d'un condensateur équivalent à une branche $R_2 C_2$ avec $R_2$ = 180Ω , $C_2$ = 1nf (ligne de mesure de longueur 100 m .

La figure 15 représente la tension $V_D$ proportionnelle à $|v_i (\ell)|$, c'est-à-dire une tension proportionnelle au module de la tension incidente en sortie de ligne lorsque la tension incidente $|v_i(0)|$ est maintenue constante en entrée de ligne. La figure 15 représente donc le coefficient d'atténuation pour une ligne courte et une ligne longue.

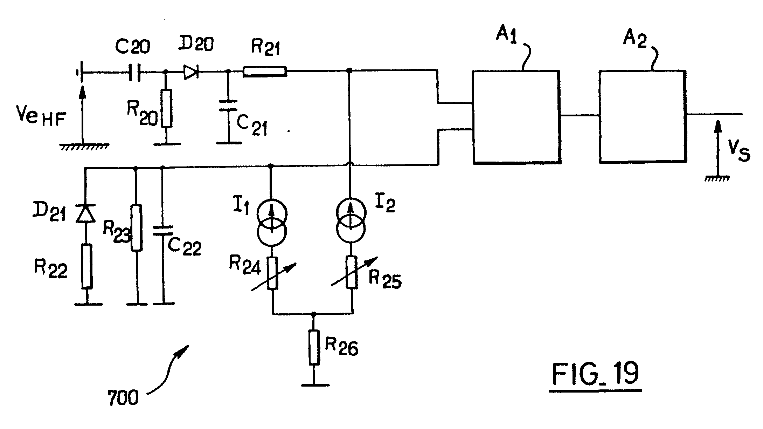

CIRCUIT DE DETECTION 700 ILLUSTRE SUR LA FIGURE 19

Le circuit de détection 700 illustré sur la figure 19 a pour fonction de détecter l'onde totale, selon une loi quadratique, dans le cadre de la technique de mesure sur ligne longue précitée.

Ce circuit de détection comprend deux diodes de Schottky $D_{20}$, $D_{21}$. La diode $D_{20}$ sert de détecteur quadratique des tensions très haute fréquence, alors que la diode $D_{21}$ sert d'élément de référence.

La sortie du générateur VHF est reliée par l'intermédiaire d'un condensateur $C_{20}$ à l'anode de la diode $D_{20}$. Le point commun au condensateur $C_{20}$ et à l'anode de la diode $D_{20}$ est relié à la masse par l'intermédiaire d'une résistance $R_{20}$. La cathode de la diode $D_{20}$ est reliée à la masse par l'intermédiaire d'un condensateur $C_{21}$ et est reliée à une première entrée d'un amplificateur différentiel $A_1$ par l'intermédiaire d'une résistance $R_{21}$. La résistance $R_{20}$ adapte l'entrée du détecteur à 50Ω. Le condensateur $C_{21}$ et la résistance $R_{21}$ forment un filtre passe-bas.

L'anode de la diode $D_{21}$ est reliée à la masse par l'intermédiaire d'une résistance $R_{22}$. La cathode de la diode $D_{21}$ est reliée à la seconde entrée de l'amplificateur différentiel $A_1$. Cette cathode est également reliée à la masse par l'intermédiaire d'une cellule comprenant en parallèle une résistance $R_{23}$ et un condensateur $C_{22}$.

Les diodes $D_{20}$ et $D_{21}$ sont polarisées par des générateurs de courant continu $I_1$ et $I_2$, associés à des résistances variables respectives $R_{24}$ et $R_{25}$ et à une résistance commune de mise à la masse $R_{26}$, pour augmenter la sensibilité du détecteur.

L'amplificateur différentiel $A_1$ en plus de l'amplification du signal sert à éliminer l'effet du courant continu de polarisation des deux diodes.

La sortie de l'amplificateur différentiel $A_1$ attaque un second étage amplificateur $A_2$.

La tension d'entrée $V_{eHF}$ appliquée au condensateur $C_{20}$ étant de forme sinusoïdale :

$$(67) \quad V_{eHF} = V_m \sin (\omega t + \phi),$$

à la sortie de l'étage amplificateur $A_2$ on récupère une tension continue $v_s$ qui obéit à la loi :

$$(68) \quad V_s = K . G_1 . G_2 . R_{ch} . Is.Vm^2$$

dans laquelle

| | |
|---|---|
| K | représente une constante, |
| $G_1$ et $G_2$ | représentent le gain de l'amplificateur différentiel $A_1$ et le gain de l'étage amplificateur $A_2$, |
| $R_{ch}$ | représente la résistance de charge, |
| Is | représente le courant de saturation de la diode détectrice $D_{20}$ et |
| $V_m$ | représente la tension crête de l'onde très haute fréquence. |

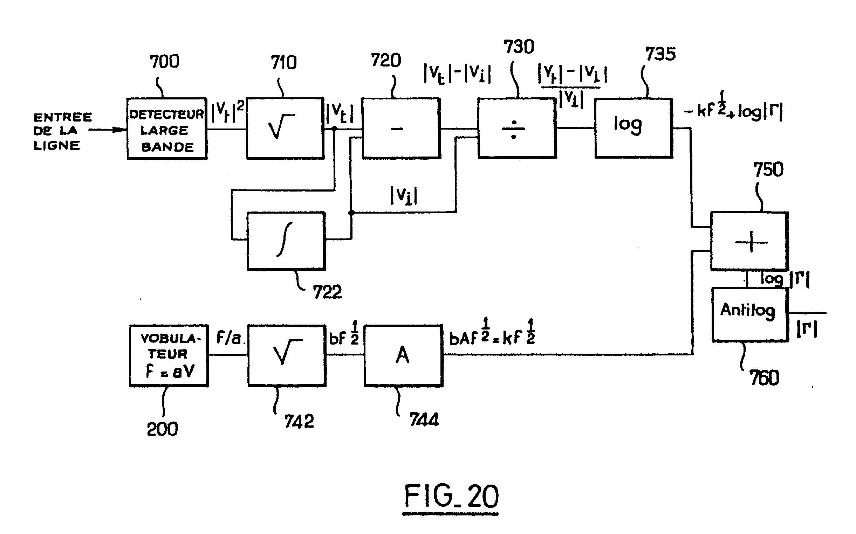

CIRCUIT DE CORRECTION ILLUSTRE SUR LA FIGURE 20.

Comme indiqué précédemment la tension totale en entrée de ligne est donnée par la relation :

$$(27) \quad v_t = v_i + v_r = v_i [1 + |\Gamma| e^{-2\alpha(\omega)1} e^{j(\psi - 21\omega/v)}].$$

Etant donné l'importance de la longueur de la ligne, la phase de l'onde réfléchie $v_r$ varie très vite avec la pulsation. On peut admettre que les fonctions $|\Gamma|(\omega)|e^{-2\alpha(\omega)1}$ et $\psi(\omega)$ varient beaucoup plus lentement. Pour la détermination de $|\Gamma(\omega)|$, on considère simplement l'enveloppe supérieure de la courbe donnant $v_t$ soit

$$(69) \qquad v_t = v_i [1 + |\Gamma|e^{-2\alpha(\omega)1}]$$

et

$$(70) \qquad \frac{|v_t - |v_i||}{|v_i|} = |\Gamma|e^{-2\alpha(\omega)1}$$

avec

$$(71) \qquad \alpha = \frac{66 \, \eta_o \sqrt{\varepsilon r}(1/a + 1/b)}{4 R_c Co} f^{1/2}$$

relation dans laquelle

2a et 2b    représentent respectivement les diamètres intérieur et extérieur de la ligne coaxiale utilisée,
$R_c$    représente la résistance caractéristique de la ligne,
Co    représente la vitesse de propagation dans le vide, et
f    représente la fréquence de l'onde transmise à travers la ligne.

Le terme $e^{-2\alpha(\omega)1}$ qui intervient dans la relation (70) pour déterminer $|\Gamma|$ à l'aide des modules $|v_t|$ et $|v_i|$ constitue un terme pertubateur. Ce terme peut être déterminé par calcul connaissant $\alpha(\omega)$.

Néanmoins, le circuit illustré sur la figure 20 permet d'éliminer le terme précité $e^{-2\alpha(\omega)1}$.

On retrouve sur cette figure 20 le circuit détecteur 700 illustré sur la figure 19 qui génère à sa sortie un signal $v_s$ proportionnel à $|v_t|^2$.

La sortie du circuit détecteur 700 attaque un opérateur 710 établissant une racine carrée, qui génère à sa sortie un signal proportionnel à $|v_t|$.

La sortie de l'opérateur 710 attaque d'une part, la première entrée d'un opérateur soustracteur 720, d'autre part, un opérateur intégrateur 722 qui génère à sa sortie un signal proportionnel à $|v_i|$. La sortie de l'opérateur 722 est reliée à la seconde entrée de l'opérateur soustracteur 720. Ce dernier génère en sortie un signal proportionnel à $|v_t| - |v_i|$ et attaque la première entrée d'un opérateur diviseur 730. La seconde entrée de cet opérateur 730 est reliée à la sortie de l'opérateur intégrateur 722.

Ainsi, l'opérateur diviseur 730 génère à sa sortie un signal proportionnel à

$$\frac{|v_t| - |v_i|}{|v_i|}.$$

Ce signal est appliqué à l'entrée d'un opérateur logarithmique 735.

Celui-ci génère à sa sortie un signal $-kf^{1/2} + Log|\Gamma|$ (voir relations 70 et 71).

La sortie de l'opérateur 735 est reliée à la première entrée d'un étage additionneur 750.

Le circuit de correction illustré sur la figure 20 utilise également le générateur de dent de scie 200 précité commandant la vobulation du générateur VHF. Ce générateur 200 délivre une tension proportionnelle à la fréquence f.

Il attaque un opérateur 742 de prise de la racine carrée qui génère en sortie un signal proportionnel à $f^{1/2}$.

Ce signal est appliqué à un étage amplificateur 744 dont le gain est adapté pour délivrer en sortie un signal proportionnel à $kf^{1/2}$.

21

EP 0 207 860 B1

Ce signal est appliqué à la seconde entrée de l'étage additionneur 750. Celui-ci génère donc à sa sortie un signal proportionnel à log|Γ| et attaque un opérateur Antilog 760. Ce dernier génère à sa sortie un signal directement proportionnel à |Γ|,soit directement proportionnel au coefficient de réflexion.

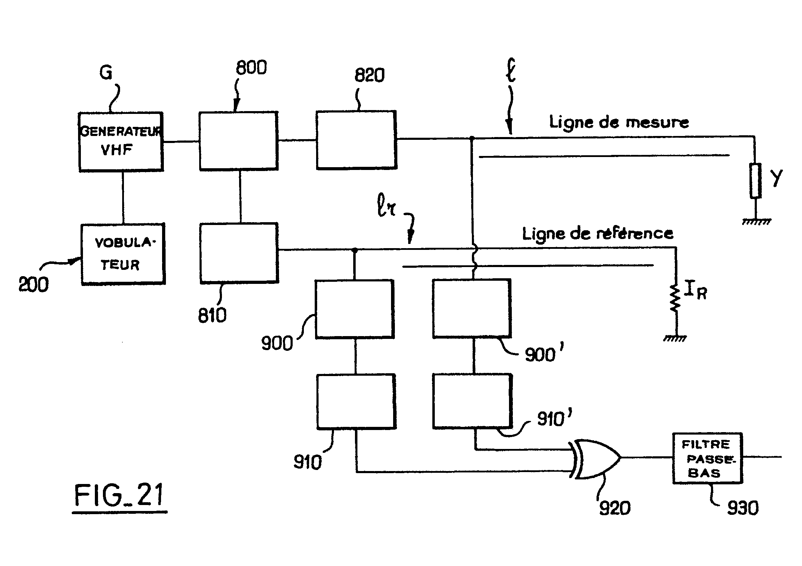

<u>CIRCUIT ILLUSTRE SUR LA FIGURE 21.</u>

Le circuit illustré sur la figure 21 permet de déterminer la phase de l'élément connecté en bout de ligne.

Ce circuit utilise une ligne de référence $l_r$ fermée sur une impédance résistive réelle $l_R$ délivrant une phase de référence. Cette ligne de référence $l_r$ a la même longueur que la ligne l reliant le générateur VHF référencé G à l'impédance Y à analyser.

L'onde incidente issue du générateur VHF est dirigée par l'intermédiaire d'un coupleur directif 800, à travers le bras principal de celui-ci sur la ligne de mesure l, et à travers le bras de couplage sur la ligne de référence $l_r$.

Plus précisément, le coupleur directif 800 attaque la ligne de mesure l par l'intermédiaire d'un étage séparateur adaptateur d'impédance 820 et attaque la ligne de référence $l_r$ par l'intermédiaire d'un étage séparateur adaptateur d'impédance 810.

L'onde totale est détectée en entrée de chacune des 2 lignes par des circuits de détection 900, 900'.

Ces derniers attaquent des circuits comparateurs 910, 910' (qui comparent la sortie des circuits de détection 900, 900' à une valeur seuil et basculent selon le résultat de la comparaison) dont les sorties sont reliées respectivement aux entrées d'une porte ou exclusif 920. Ce dernier attaque un filtre passe-bas 930.

Si l'élément Y qui charge la ligne de mesure l est de nature différente de $l_R$, les ondes totales détectées ou les modules des deux ondes totales variant suivant une loi sinusoïdale basse fréquence, avec la fréquence appliquée aux lignes, sont déphasés l'un par rapport à l'autre.

Les détecteurs 900, 900', les comparateurs 910, 910', la porte ou exclusif 920 et le filtre passe-bas 930 constituent un phasemètre basse fréquence qui génère un signal proportionnel à la phase de l'élément Y connecté en sortie de la ligne de mesure l.

**Revendications**

1.  Procédé de test rapide, dans la gamme V.H.F., de dipôles passifs, du type comprenant les étapes consistant à :

    i) connecter un générateur (G) de signal électrique de fréquence située dans la gamme V.H.F. en tête d'une ligne (L) et connecter un dipôle à tester (Y) à l'autre extrémité de la ligne (L) sous forme d'impédance terminale,

    ii) alimenter la ligne (L) grâce au générateur (G) par une onde incidente Vi périodique dont la fréquence est modulable dans la gamme V.H.F. pendant la durée du test,

    iii) détecter au moins une tension sur la ligne (L) pour définir l'évolution du coefficient de réflexion Γ(ω) sur la gamme V.H.F. et déterminer, à partir de ce coefficient de réflexion Γ(ω), l'impédance du dipôle à tester Y(ω), selon la relation

$$ Y(\omega) \ = \ \frac{1}{R_C} \ \frac{1 - \Gamma(\omega)}{1 + \Gamma(\omega)} $$

dans laquelle $R_c$ représente la résistance caractéristique de la ligne, caractéristé par le fait que:
- la ligne (L) est constitué d'une ligne à constantes réparties de grande longueur par rapport aux longueurs d'ondes utilisées, soit de l'ordre de 100 m, et
- l'étape iii) consiste à
  * détecter en tête de ligne la tension totale Vt, représentative de la somme de l'onde réfléchie Vr et de l'onde incidente Vi,
  * détecter le module des maxima $Vt_M$ et des minima $Vt_m$ de la tension totale Vt et
  * déterminer le module |Γ| du coefficient de réflexion sur la base de la relation :

EP 0 207 860 B1

$$|\Gamma(\omega)| = \frac{|Vr|}{|Vi|} e^{2\alpha(\omega)l} =$$

$$= \frac{|Vt|_M - |Vt|_m}{|Vt|_M + |Vt|_m} e^{2\alpha(\omega)l}$$

dans laquelle

$\alpha$ représente l'atténuation de la ligne (L),

l représente la longueur de la ligne (L) et

$\omega$ représente la pulsation.

2. Procédé de test rapide selon la revendication 1, caractérisé par le fait que à l'étape ii) la ligne (L) est alimentée par une onde incidente $v_i$ périodique dont la période varie sur une gamme de l'ordre de 1 $\mu$s à 5ns sur une durée de test d'environ 1s.

3. Procédé de test rapide selon l'une des revendications 1 à 2, caractérisé par le fait que au cours de l'étape ii), la ligne (L) est alimentée par une onde incidente $v_i$ dont la période est modulée par vobulation sur la gamme V.H.F. selon une fonction linéaire ou logarithmique du temps.

4. Procédé de test rapide selon l'une des revendications 1 à 3, pour l'analyse de condensateurs, caractérisé par le fait que, le module d'admittance |Y| du dipôle évoluant comme une suite de paliers de valeurs $G_j$, ceux-ci sont déterminés à l'étape iii) sur la base de la relation :

$$G_j = \frac{1}{R_c} \frac{1 - |\Gamma_j|}{1 + |\Gamma_j|}$$

dans laquelle

$R_c$ représente l'impédance caractéristique de la ligne et

$|\Gamma_j|$ représente le module du coefficient de réflexion.

5. Procédé de test rapide selon la revendication 4, pour l'analyse de condensateurs sous forme d'un réseau de n branches parallèles comportant chacune en série une résistance $R_j$ et une capacitance $C_j$, caractérisé par le fait que la résistance $R_j$ et la capacitance $C_j$ sont déterminées à l'étape iii), sur la base des relations :

$$\frac{1}{R_j} = G_j - G_{j-1}$$

dans laquelle $G_j$ et $G_{j-1}$ représentent deux paliers successifs du module d'admittance |Y|, et

$$C_j = \frac{G_j - G_{j-1}}{\omega_j}$$

dans laquelle $\omega_j$ représente la pulsation critique de la branche considérée.

6. Procédé de test rapide selon l'une des revendications 1 à 5, caractérisé par le fait que l'étape ii) est réalisée à l'aide d'un oscillateur (100) à fréquence variable, à commutation automatique de bandes de

23

EP 0 207 860 B1

fréquence.

7. Procédé de test rapide selon la revendication 6, caractérisé par le fait que le circuit bouchon de l'oscillateur (100) est associé à une diode varicap ($D_v$) polarisée par un signal en dents de scie (200) assurant la vobulation à l'intérieur de chaque bande de fréquence, le circuit bouchon de l'oscillateur comportant une pluralité de selfs (L301, L302, L303, L304) alternativement mises en service pour assurer la commutation de bandes de fréquence.

8. Procédé de test rapide selon la revendication 7, caractérisé par le fait que les signaux de commutation de bandes de fréquence (400) assurant alternativement la mise en service des selfs (L301, L302, L303, L304) du circuit bouchon de l'oscillateur sont générés à partir du signal en dents de scie (200) polarisant la diode varicap ($D_v$).

9. Procédé de test rapide selon la revendication 8, caractérisé par le fait que les signaux de commutation de bandes de fréquence sont générés en sortie d'un registre à décalage (430) à entrée série et sorties parallèles commandé par le générateur de signal en dents de scie (200).

10. Procédé de test rapide selon l'une des revendications 1 à 9, caractérisé par le fait qu'il comprend en outre les étapes consistant à :
   - connecter une ligne de référence (lr) ayant la même longueur que la ligne première citée (L) au générateur (G), par l'intermédiaire d'un coupleur directif (800),
   - connecter une résistance pure à la deuxième extrémité de la ligne de réfrence (lr) et
   - connecter un phasemètre (900, 900', 910, 910', 920, 930) basse fréquence entre la première extrémité de la ligne première citée (L) et la première extrémité de la ligne de référence (lr) pour détecter l'argument du coefficient de réflexion.

11. Dispositif de test rapide, dans la gamme V.H.F., de dipôles passifs pour la mise en oeuvre du procédé selon l'une des revendications 1 à 10 du type comprenant :
   - un générateur (G) de signal électrique de fréquence variable dans la gamme V.H.F.,
   - une ligne (L) connectée en tête audit générateur (G), et en sortie au dipôle à tester (Y) formant impédance terminale,
   - des moyens de détection d'au moins une tension sur la ligne pour définir l'évolution du coefficient de réflexion $\Gamma(\omega)$ sur la gamme V.H.F.
   - et des moyens aptes à déterminer, à partir de ce coefficient de réflexion $\Gamma(\omega)$, l'impédance du dipôle à tester $Y(\omega)$, selon la relation

$$Y(\omega) = \frac{1}{R_C} \frac{1 - \Gamma(\omega)}{1 + \Gamma(\omega)}$$

dans laquelle $R_c$ représente la résistance caractéristique de la ligne, caractérisé par le fait que
   - la ligne (L) est une ligne à constantes réparties de grande longueur par rapport aux longueurs d'ondes utilisées, soit de l'ordre de 100 m,
   - les moyens de détection sont conçues pour détecter en tête de ligne, la tension totale Vt représentative de la somme de l'onde réfléchie Vr et de l'onde incidente Vi, et il est prévu
   - des moyens aptes à détecter le module des maxima $Vt_M$ et des minima $Vt_m$ de la tension totale Vt et
   - des moyens aptes à déterminer le module $|\Gamma|$ du coefficient de réflexion sur la base de la relation :

24

EP 0 207 860 B1

$$|\Gamma(\omega)| \quad = \frac{|Vr|}{|Vi|}\, e^{2\alpha(\omega)l}$$

$$= \frac{|Vt|_M - |Vt|_m}{|Vt|_M + |Vt|_m}\, e^{2\alpha(\omega)l}$$

dans laquelle

$\alpha$     représente l'atténuation de la ligne,

$l$     représente la longueur de la ligne, et

$\omega$     représente la pulsation.

**12.** Dispositif de test rapide, selon la revendication 11,
caractérisé par le fait qu'il comprend :
- un détecteur (700) de l'onde totale, selon une loi quadratique, en entrée de ligne,
- un premier opérateur de prise de racine carrée (710) relié à la sortie du détecteur (700),
- un intégrateur (722) relié à la sortie du premier opérateur de prise de racine carrée (710),
- un soustracteur (720) dont une première entrée est reliée à la sortie du premier opérateur de prise de racine carrée (710) et la seconde entrée est reliée à la sortie de l'intégrateur (722),
- un diviseur (730) dont une première entrée est reliée à la sortie du soustracteur (720) et la seconde entrée est reliée à la sortie de l'intégrateur (722),
- un opérateur de prise de logarithme (735) relié à la sortie du diviseur (730),
- un générateur (200) délivrant une tension proportionnelle à la fréquence appliquée sur la ligne,
- un second opérateur de prise de racine carrée (742) relié à la sortie du générateur (200),
- un étage amplificateur (744) relié à la sortie du second opérateur de prise de racine carrée,
- un additionneur (750) dont une première entrée est reliée à la sortie de l'opérateur de prise de logarithme (735) et dont une seconde entrée est reliée à la sortie de l'étage amplificateur (744), et
- un opérateur antilogarithmique (760) relié à la sortie de l'additionneur (750) et qui délivre à sa sortie un signal directement proportionnel au module du coefficient de réflexion.

**13.** Dispositif de test rapide selon l'une des revendications 11 et 12, caractérisé par le fait qu'il comprend en outre :
- une ligne de référence (lr) ayant la même longueur que la ligne première citée (L) au générateur (G) par l'intermédiaire d'un coupleur directif (800),
- une résistance pure connectée à la deuxième extrémité de la ligne de référence, et
- un phasemètre basse fréquence (900, 900', 910, 910', 920, 930) connecté entre la première extrémité de la ligne première citée (L) et la première extrémité de la ligne de référence (lr) pour détecter l'argument du coefficient de réflexion.

**14.** Dispositif de test rapide selon la revendication 13,
caractérisé par le fait que le phasemètre basse fréquence comprend :
- des détecteurs (900, 900') détectant l'onde totale en entrée de chacune des deux lignes,
- des comparateurs (910, 910') qui comparent les niveaux de sortie des détecteurs à une valeur seuil,
- une porte ou exclusif (920) dont les entrées sont reliées respectivement aux sorties des comparateurs et
- un filtre passe-bas (930) relié à la sortie de la porte ou exclusif et qui délivre un signal proportionnel à la phase de l'impédance à analyser.

**15.** Dispositif de test rapide selon l'une des revendications 11 à 14, caractérisé par le fait que le générateur (G) est adapté pour alimenter la ligne (L) par une onde incidente $v_i$ périodique dont la période varie sur une gamme de l'ordre de 1 $\mu$s à 5ns sur une durée de test d'environ 1s.

**16.** Dispositif de test rapide selon l'une des revendications 11 à 15, pour l'analyse de condensateurs, caractérisé par le fait qu'il comprend des moyens aptes à déterminer les paliers $G_i$ du module

25

EP 0 207 860 B1

d'admittance |Y| du dipôle sur la base de la relation :

$$G_j = \frac{1}{R_c} \frac{1 - |\Gamma_j|}{1 + |\Gamma_j|}$$

dans laquelle :

$R_c$        représente l'impédance caractéristique de la ligne, et

$|\Gamma_j|$        représente le module du coefficient de réflexion.

17. Dispositif de test rapide selon la revendication 16, pour l'analyse de condensateurs, sous forme d'un réseau de n branches parallèles comportant chacune en série une résistance $R_j$ et une capacitance $C_j$, caractérisé par le fait qu'il comprend
   - des moyens aptes à déterminer la résistance $R_j$ sur la base de la relation

$$\frac{1}{R_j} = G_j - G_{j-1}$$

dans laquelle

$G_j$ et $G_{j-1}$        représentent deux paliers successifs du module d'admittance |Y| et
   - des moyens aptes à déterminer la capacitance $C_j$ sur la base de la relation

$$C_j = \frac{G_j - G_{j-1}}{\omega_j}$$

dans laquelle

$\omega_j$        représente la pulsation critique de la branche considérée.

18. Dispositif de test selon l'une des revendications 11 à 17, caractérisé par le fait que le générateur (G) comprend un oscillateur (100) à fréquence variable, à commutation automatique de bandes de fréquence.

19. Dispositif de test selon la revendication 18, caractérisé par le fait qu'il comprend un générateur de signal en dents de scie (200), que le circuit bouchon de l'oscillateur est associé à une diode varicap ($D_v$) polarisée par le signal en dents de scie (200) assurant la vobulation à l'intérieur de chaque bande de fréquence, le circuit bouchon de l'oscillateur comportant une pluralité de selfs (L301, L302, L303, L304) alternativement mises en service pour assurer la commutation de bandes de fréquence.

20. Dispositif de test selon la revendication 19 caractérisé par le fait que le générateur de signal en dents de scie (200) génère également les signaux de commutation (400) de bandes de fréquence assurant alternativement la mise en service des selfs (L301, L302, L303, L304) du circuit bouchon de l'oscillateur.

21. Dispositif de test selon la revendication 20 caractérisé par le fait qu'il comprend un registre à décalage (430) à entrée série et sorties parallèles commandé par le générateur de signal en dents de scie (200) et générant en sortie les signaux de commutation de bandes de fréquence.

22. Dispositif de test selon la revendication 11 caractérisé par le fait qu'il comprend en outre des moyens aptes à déterminer l'argument $\psi(\omega)$ du coefficient de réflexion $\Gamma(\omega)$ sur la base des relations :

26

$$\psi_M (\omega_M) = 2k\pi + \frac{2\ell}{v} \omega_M$$

et

$$\psi_m (\omega_m) = (2k+1)\pi + \frac{2\ell}{v} \omega_m$$

dans lesquelles

v    représente la vitesse de propagation,

$\omega_M$    représente la pulsation correspondant à un maxima, et

$\omega_m$    représente la pulsation correspondant à un minima.

## Claims

1. A method of rapidly testing passive two-terminal devices in the VHF range, said method comprising the steps of :

i) connecting an electric signal generator (G) capable of generating frequencies in the VHF range, to the head of a line (L) and connecting a two-terminal device to be tested (Y) to the other end of the line (L) as a terminal impedance,

ii) feeding the line (L) using the generator (G) with a periodic incident wave Vi whose frequency is modulated in the VHF range while the test is being performed.

iii) detecting at least a voltage on the line (L) to define the behavior of the reflection coefficient $\Gamma(\omega)$ in the VHF range, and to determine, from this reflection coefficient $\Gamma(\omega)$, the impedance of the two-terminal device to be tested $Y(\omega)$, according to the relation

$$Y(\omega) = \frac{1}{Rc} \cdot \frac{1 - \Gamma(\omega)}{1 + \Gamma(\omega)}$$

wherein Rc is the characteristic impedance of the line, characterised by the fact that :

- the line (L) is a distributed constant transmission line having a long length in regard to the used wavelengths, ie about 100 m, and
- the step iii consists in
  * detecting at the head of the line the total voltage Vt, representative of the sum of the reflected wave Vr and the incident wave Vi,
  * detecting the modulus of the maxima $Vt_M$ and of the minima $Vt_m$ of the total voltage Vt, and
  * determining the modulus $|\Gamma|$ of the reflection coefficient on the base of the relation :

$$|\Gamma(\omega)| = \frac{|Vr|}{|Vi|} e^{2\alpha(\omega)\ell} = \frac{|Vt|_M - |Vt|_m}{|Vt|_M + |Vt|_m} e^{2\alpha(\omega)\ell}$$

wherein

$\alpha$    represents the attenuation of the line (L),

l    represents the length of the line (L) and

$\omega$    represents the pulsation.

2. A method according to claim 1 characterised by the fact that wherein during step ii) the line (L) is fed with a periodic incident wave $v_i$ whose period varies over a range from about 1 $\mu$s to about 5 ns over a test duration of about 1 s.

3. A method according to one of claims 1 and 2, characterised by the fact that during step ii) the line (L) is fed with a periodic incident wave $v_i$ whose period is modulated by wobbulation over the VHF range using a linear or a logarithmic function of time.

4. A method according to one of claims 1 to 3 for analyzing capacitors, characterised by the fact that the modulus of the admittance $|Y|$ of the two-terminal network varies as a series of levels of value $G_j$, which levels are determined during step iii) on the basis of the following equation :

$$G_j = \frac{1}{R_c} \frac{1 - |\Gamma_j|}{1 + |\Gamma_j|}$$

where

$R_c$    is the characteristic impedance of the line, and

$|\Gamma_j|$    is the modulus of the reflection coefficient.

5. A method according to claim 4, for analyzing capacitors in the form of a ladder network comprising n parallel branches each of which is constituted by a resistance $R_j$ and a capacitance $C_j$ connected in series, characterised by the fact that the resistance $R_j$ and the capacitance $C_j$ are determined during step iii) on the basis of the equation :

$1/R_j = G_j - G_{j-1}$

where $G_j$ and $G_{j-1}$ are two successive levels in the modulus of the admittance $|Y|$ , and the equation

$C_j = (G_j - G_{j-1})/w_j$

where $w_j$ is the resonant angular frequency of the j-th branch.

6. A method according to one of claims 1 to 5 characterised by the fact that step ii) is performed by means of a variable frequency oscillator (100) with automatic frequency band switching.

7. A method according to claim 6 , characterised by the fact that the wavetrap of the oscillator (100) is associated with a varicap diode ($D_v$) which is biased by a sawtooth signal (200) for providing wobbulation within each frequency band, the wave trap of the oscillator including a plurality of inductors (L301, L302, L303, L304) which are successively switched into or out of circuit in order to provide said frequency band switching.

8. A method according to claim 7, characterised by the fact that the frequency band switching signals (400) for successively switching the inductors (L301, L302, L303, L304) of the wavetrap into or out of circuit are generated from the sawtooth signal (200) which biases the varicap diode ($D_v$).

9. A method according to claim 8, characterised by the fact that the frequency band switching signals are generated at the outputs from a serial-in, parallel-out shift register (430) controlled by the signal from the sawtooth generator (200).

10. A method according to one of claims 1 to 9 characterised by the fact that it further comprises the steps of :
   - connecting a reference line (lr) having the same length that the first cited line (L), to the generator (G), by means of a directional coupler (800),
   - connecting a pure resistance to the second end of the reference line (lr) and
   - connecting a low frequency phasemeter (900, 900', 910, 910', 920, 930) between the first end of the first cited line (L) and the first end of the reference line (lr) to detect the phase of the reflection coefficient.

11. An apparatus for rapidly testing passive two terminal devices in the VHF range, for implementing the method according to one of claims 1 to 10, comprising :

- an electric signal generator (G) capable of generating frequencies in the VHF range,
- a line (L) connected at its head to the generator (G) and at its output to the two terminal (Y) to be tested, as a terminal impedance,
- means for detecting at least a voltage on the line (L) to define the behavior of the reflection coefficient $\Gamma(\omega)$ in the VHF range, and means to determine, from this reflection coefficient $\Gamma(\omega)$, the impedance of the two-terminal device to be tested $Y(\omega)$, according to the relation

$$Y(\omega) = \frac{1}{R_c} \frac{1 - \Gamma(\omega)}{1 + \Gamma(\omega)}$$

wherein $R_c$ is the characteristic impedance of the line, characterised by the fact that :
- the line (L) is a distributed constant transmission line having a long length in regard to the used wavelengths, ie about 100 m, and
- the means for detecting are provided to detect at the head of the line the total voltage Vt, representative of the sum of the reflected wave Vr and the incident wave Vi, and it is provided
- means for detecting the modulus of the maxima $Vt_M$ and of the minima $Vt_m$ of the total voltage Vt, and
- means for determining the modulus $|\Gamma|$ of the reflection coefficient on the base of the relation :

$$|\Gamma(\omega)| = \frac{|Vr|}{|Vi|} e^{2\alpha(\omega)l} = $$
$$= \frac{|Vt|_M - |Vt|_m}{|Vt|_M + |Vt|_m} e^{2\alpha(\omega)l}$$

wherein
$\alpha$  represents the attenuation of the line (L)-
l  represents the length of the line (L) and
$\omega$  represents the pulsation.

12. Apparatus according to claim 11 characterised by the fact that it comprises :

a detector (700) located at the inlet to the line and suitable for detecting the total wave using a quadratic law;

a first square root extractor circuit (710) connected to the output from said detector (700);

an integrator (722) connected to the output from the first square root extractor circuit (710);

a subtractor (720) having a first input connected to the output from the first square root extractor circuit (710) and having its second input connected to the output from the integrator (722);

a divider (730) having a first input connected to the output from the subtractor (720) and its second input connected to the output from the integrator (722);

a logarithm extractor circuit (735) connected to the output from the divider (730);

a frequency signal generator (200) for delivering a voltage proportional to the frequency applied to the line;

a second square root extractor circuit (742) connected to the output from said frequency signal generator (200);

an amplifier stage (744) connected to the output from said second square root extractor circuit;

an adder (750) having a first input connected to the output from the logarithm extractor circuit (735) and having its second input connected to the output from the amplifier stage (744); and

an antilogarithm circuit (760) connected to the output from the adder (750) and delivering a signal at its output which is directly proportional to the modulus of the reflection coefficient.

13. Apparatus according to one of claims 11 and 12 characterised by the fact that it further comprises :
- a reference line (lr) having the same length that the first cited line (L), connected to the generator (G), by means of a directional coupler (800),
- a pure resistance connected to the second end of the reference line (lr) and

- a low frequency phasemeter (900, 900', 910, 910', 920, 930) connected between the first end of the first cited line (L) and the first end of the reference line (lr) to detect the phase of the reflection coefficient.

14. Apparatus according to claim 13, characterised by the fact that the low frequency phasemeter comprises :

first and second detectors (900, 900') respectively connected to detect the total wave at the input to each of said lines;

first and second threshold comparators (910, 910') connected to compare the output levels from respective ones of said detectors with a threshold value;

an exclusive-OR gate (920) having its inputs connected to respective outputs from said comparators; and

a lowpass filter (930) connected to the output from said exclusive-OR gate and delivering a signal proportional to the phase of the impedance to be analyzed.

15. Apparatus according to one of claims 11 to 14, characterised by the fact that the generator (G) is adapted to feed the line (L) with a periodic incident wave $v_i$ whose period varies over a range from about 1 $\mu$s to about 5 ns with a test duration of about ls.

16. Apparatus according to one of claims 11 to 15, for analyzing capacitors, characterised by the fact that it comprises means suitable for determining the levels $G_j$ in the modulus of the admittance $|Y|$ of the two-terminal network constituted by the capacitor using the equation :

$$G_j = \frac{1}{R_c} \frac{1 - |\Gamma_j|}{1 + |\Gamma_j|}$$

where

$R_c$     is the characteristic impedance of the line, and

$|\Gamma_j|$     is the modulus of the reflection coefficient.

17. Apparatus according to claim 16, for analyzing capacitors in the form of a ladder network comprising n parallel branches each of which is constituted by a resistance $R_j$ and a capacitance $C_j$ connected in series, the method being characterised by the fact that it comprises :

means suitable for determining the resistance $R_j$ the basis of the equation :

$1/R_j = G_j - G_{j-1}$

where $G_j$ and $G_{j-1}$ are two successive levels in the modulus of the admittance $|Y|$ ; and

means suitable for determining the capacitance $C_j$ on the basis of the equation

$C_j = (G_j - G_{j-1})/w_j$

where $w_j$ is the resonant angular frequency of the j-th branch.

18. Apparatus according to one of claims 11 to 17, wherein the generator (G) includes a variable frequency oscillator (100) with automatic frequency band switching.

19. Apparatus according to claim 18, characterised by the fact that it includes a sawtooth signal generator (200), and the wavetrap of the oscillator is associated with a varicap diode ($D_v$) which is biased by the sawtooth signal (200) from said generator for providing wobbulation within each frequency band, the wavetrap of the oscillator including a plurality of inductors (L301, L302, L303, L304) which are successively switched into or out of circuit in order to provide said frequency band switching.

20. Apparatus according to claim 19, characterised by the fact that the sawtooth signal generator (200) also generates the frequency band switching signals (400) for progressively switching the inductors (L301,

EP 0 207 860 B1

L302, L303, L304) of the oscillator wavetrap into or out of service.

21. Apparatus according to claim 20, characterised by the fact that it comprises a serial-in, parallel-out shift register (430) controlled by the sawtooth signal generator (200), with the signals present on the outputs of the shift register constituting the frequency band switching signals.

22. Apparatus according to claim 11, characterised by the fact that it further comprises means capable to determine the phase $\psi(\omega)$ of the reflection coefficient $\Gamma(\omega)$ on the base of the relations :

$$\psi_M(\omega_M) = 2\,k\pi + \frac{2\ell}{v}\,\omega_M$$

and

$$\psi_m(\omega_m) = (2k+1)\,\pi + \frac{2\ell}{v}\,\omega_m$$

wherein

$v$      represents the propagation speed,

$\omega_M$      represents the pulsation corresponding to the maxima,

and

$\omega_m$      represents the pulsation corresponding to the minima.

## Patentansprüche

1. Verfahren zum schnellen Testen von passiven Dipolen im VHF-Bereich, das derart ist, daß es Verfahrensschritte umfaßt, die darin bestehen:

i) einen Generator (G) eines elektrischen Signals mit einer Frequenz im VHF-Bereich mit der Spitze einer Leitung (L) zu verbinden und einen zu testenden Dipol (Y) mit dem anderen Ende der Leitung (L) in der Form einer Abschlußimpedanz zu verbinden,

ii) die Leitung (L) mit Hilfe des Generators (G) mit einer einfallenden, periodischen Welle Vi zu versorgen, deren Frequenz während der Prüfdauer im VHF-Bereich modulierbar ist,

iii) wenigstens eine Spannung auf der Leitung (L) festzustellen, um die Entwicklung eines Reflexionskoeffizienten $\Gamma(\omega)$ im VHF-Bereich zu definieren und ausgehend von diesem Reflexionskoeffizienten $\Gamma(\omega)$ die Impedanz des zu testenden Dipols $Y(\omega)$ entsprechend der Beziehung

$$Y(\omega) = \frac{1}{Rc} \cdot \frac{1 - \Gamma(\omega)}{1 + \Gamma(\omega)}$$

zu bestimmen, in der Rc den charakteristischen Widerstand der Leitung darstellt, gekennzeichnet durch die Tatsache, daß:

- die Leitung (L) aus konstanten Unterteilungen großer Länge bezüglich der verwendeten Wellenlängen, also in der Größenordnung von 100m, ist und daß der Verfahrensschritt iii) darin besteht

\* an der Spitze der Leitung die Gesamtspannung Vt festzustellen, die die Summe der reflektierten Welle Vr und der einfallenden Welle Vi darstellt,

\* den Betrag der Maxima $Vt_M$ und der Minima $Vt_m$ der Gesamtspannung Vt festzustellen und

\* den Betrag $|\Gamma|$ des Reflexionskoeffizienten auf der Basis der Beziehung:

31

$$|\Gamma(\omega)| = \frac{|Vr|}{|Vi|} e^{2\alpha(\omega)l} =$$

$$= \frac{|Vt|M - |Vt|m}{|Vt|M + |Vt|m} e^{2\alpha(\omega)l}$$

zu bestimmen,
in der $\alpha$ die Dämpfung der Leitung (L), l die Länge der Leitung (L) und $\omega$ die Frequenz darstellt.

2. Schnelles Testverfahren nach Anspruch 1, gekennzeichnet durch die Tatsache, daß bei dem Schritt ii) die Leitung (L) mit einer periodischen, einfallenden Welle $v_i$ gespeist wird, deren Periode sich in einem Bereich der Größenordnung von 1 $\mu$s bis 5 ns für eine Testdauer von ungefähr 1 s ändert.

3. Schnelles Testverfahren nach einem der Ansprüche 1 bis 2, gekennzeichnet durch die Tatsache, daß bei dem Schritt ii) die Leitung (L) mit einer einfallende Welle $v_i$ gespeist wird, deren Periode durch das Wobbeln im VHF-Bereich entsprechend einer linearen oder logarithmischen Zeitfunktion moduliert wird.

4. Schnelles Testverfahren nach einem der Ansprüche 1 bis 3 zur Analyse von Kondensatoren, gekennzeichnet durch die Tatsache, daß, während sich der Betrag der Admittanz |Y| des Dipols wie eine Folge von Stufen mit Werten Gj entwickelt, diese in Schritt iii) auf der Basis der Beziehung

$$G_j = \frac{1}{Rc} \frac{1 - |\Gamma j|}{1 + |\Gamma j|}$$

bestimmt werden, in der
$R_c$ die charakteristische Impedanz der Leitung darstellt und
$|\Gamma_j|$ den Betrag des Reflexionskoeffizienten darstellt.

5. Schnelles Testverfahren nach Anspruch 4 zur Analyse von Kondensatoren in der Form eines Netzwerks mit n parallelen Zweigen, die jeweils in Reihe einen Widerstand $R_j$ und eine Kapazität $C_j$ aufweisen, gekennzeichnet durch die Tatsache, daß der Widerstand $R_j$ und die Kapazität $C_j$ in Schritt iii) basierend auf den Beziehungen $1/R_j = G_j - G_{j-1}$, wobei $G_j$ und $G_{j-1}$ zwei aufeinanderfolgende Stufen des Betrags der Admittanz |Y| darstellen, und

$$C_j = \frac{G_j - G_{j-1}}{\omega_j},$$

wobei $\omega_j$ die kritische Frequenz des betrachteten Zweigs darstellt, bestimmt werden.

6. Schnelles Testverfahren nach einem der Ansprüche 1 bis 5, gekennzeichnet durch die Tatsache, daß der Schritt ii) mit Hilfe eines Oszillators (100) mit variabler Frequenz mit automatischem Wechsel der Frequenzbänder durchgeführt wird.

7. Schnelles Testverfahren nach Anspruch 6, gekennzeichnet durch die Tatsache, daß der Schaltkreisabschluß des Oszillators (100) mit einer Diode mit variabler Kapazität (D$_v$), die durch ein Sägezahnsignal (200) polarisiert wird, das das Wobbeln im Innern jedes Frequenzbandes sicherstellt, verbunden ist, wobei der Schaltkreisabschluß eine Mehrzahl von Drosselspulen (L301, L302, L303, L304) umfaßt, die

EP 0 207 860 B1

jeweils eingeschaltet werden, um den Wechsel der Frequenzbänder sicherzustellen.

8. Schnelles Testverfahren nach Anspruch 7, gekennzeichnet durch die Tatsache, daß die Signale zum Wechseln der Frequenzbänder (400), die jeweils das Einschalten der Drosselspulen (L301, L302, L303, L304) des Abschlußschaltkreises des Oszillators sicherstellen, durch das Sägezahnsignal (200), das die Diode mit variabler Kapazität ($D_v$) polarisiert, erzeugt werden.

9. Schnelles Testverfahren nach Anspruch 8, gekennzeichnet durch die Tatsache, daß die Signale zum Wechseln der Frequenzbänder am Ausgang eines Schieberegisters (430) mit seriellem Eingang und parallelen Ausgängen durch den Generator des Sägezahnsignals (200) erzeugt werden.

10. Schnelles Testverfahren nach einem der Ansprüche 1 bis 9, gekennzeichnet durch die Tatsache, daß die Verfahrensschritte außerdem darin bestehen,
   - eine Referenzleitung (lr) mit derselben Länge wie die erstgenannte Leitung (L) mit dem Generator (G) über einen Richtungskoppler (800) zu verbinden,
   - einen reinen Widerstand mit dem zweiten Ende der Referenzleitung (lr) zu verbinden und
   - ein Niederfrequenzphasenmeßgerät (900, 900', 910, 910', 920, 930) zwischen dem ersten Ende der erstgenannten Leitung (L) und dem ersten Ende der Referenzleitung (lr) zum Feststellen des Phasenwinkels des Reflexionskoeffizienten anzuschließen.

11. Vorrichtung zum schnellen Testen von passiven Dipolen im VHF-Bereich zum Ausführen des Verfahrens nach einem der Ansprüche 1 bis 10, die derart ist, daß sie umfaßt:
   - einen Generator (G) eines elektrischen Signals mit einer variablen Frequenz im VHF-Bereich
   - eine Leitung (L), die an ihrer Spitze mit dem Generator (G) und an ihrem Ausgang mit dem zu testenden Dipol (Y) verbunden ist, wodurch eine Abschlußimpedanz gebildet wird,
   - Vorrichtungen zum Feststellen von wenigstens einer Spannung auf der Leitung (L), um die Entwicklung eines Reflexionskoeffizienten $\Gamma(\omega)$ im VHF-Bereich zu definieren, und Vorrichtungen, die geeignet sind, ausgehend von diesem Reflexionskoeffizienten $\Gamma(\omega)$ die Impedanz des zu testen den Dipols $Y(\omega)$ entsprechend der Beziehung

$$Y(\omega) = \frac{1}{Rc} \cdot \frac{1 - \Gamma(\omega)}{1 + \Gamma(\omega)} \, ,$$

in der $R_c$ den charakteristischen Widerstand der Leitung darstellt, zu bestimmen,
   gekennzeichnet durch die Tatsache, daß:
   - die Leitung (L) eine Leitung aus konstanten Unterteilungen großer Länge bezüglich der verwendeten Wellenlängen, also in der Größenordnung von 100m, ist,
   - die Detektionsvorrichtungen geeignet sind, an der Spitze der Leitung die Gesamtspannung Vt festzustellen, die die Summe der reflektierten Welle Vr und der einfallenden Welle Vi darstellt, und daß vorgesehen sind
   - Vorrichtungen, die geeignet sind, den Betrag der Maxima $Vt_M$ und der Minima $Vt_m$ der Gesamtspannung Vt festzustellen, und
   - Vorrichtungen, die geeignet sind, den Betrag $|\Gamma|$ des Reflexionskoeffizienten auf der Basis der Beziehung:

EP 0 207 860 B1

$$|\Gamma(\omega)| = \frac{|Vr|}{|Vi|} e^{2a(\omega)1} =$$

$$= \frac{|Vt|M - |Vt|m}{|Vt|M + |Vt|m} e^{2a(\omega)1} \quad ,$$

in der $\alpha$ die Dämpfung der Leitung (L), l die Lange der Leitung (L) und $\omega$ die Frequenz darstellt, festzustellen.

12. Vorrichtung zum schnellen Testen nach Anspruch 11, gekennzeichnet durch die Tatsache, daß sie umfaßt:
   - einen Detektor (700) der Gesamtwelle nach einer quadratischen Gesetzmäßigkeit an der Spitze der Leitung,
   - einen ersten Operator zum Bilden einer Quadratwurzel (710), der mit dem Ausgang des Detektors (700) verbunden ist,
   - einen Integrator (722), der mit dem Ausgang des ersten Operators zum Bilden einer Quadratwurzel (710) verbunden ist,
   - einen Subtrahierer (720), dessen erster Eingang mit dem Ausgang des ersten Operators zum Bilden einer Quadratwurzel (710) und dessen zweiter Eingang mit dem Ausgang des Integrators (722) verbunden ist,
   - einen Teiler (730), dessen erster Eingang mit dem Ausgang des Subtrahierers (720) und dessen zweiter Eingang mit dem Ausgang des Integrators (722) verbunden ist,
   - einen Operator zum Bilden eines Logarithmus (735), der mit dem Ausgang des Teilers (730) verbunden ist,
   - einen Generator (200), der eine Spannung proportional der an die Leitung angelegten Frequenz erzeugt,
   - einen zweiten Operator zum Bilden einer Quadratwurzel (742), der mit dem Ausgang des Generators (200) verbunden ist,
   - eine Verstärkerstufe (744), die mit dem Ausgang des zweiten Operators zum Bilden einer Quadratwurzel verbunden ist,
   - einen Addierer (750), dessen erster Eingang mit dem Ausgang des Operators zum Bilden eines Logarithmus (735) verbunden ist und dessen zweiter Eingang mit dem Ausgang der Verstärkerstufe (744) verbunden ist, und
   - einen antilogarithmischen Operator (760), der mit dem Ausgang des Addierers (750) verbunden ist und der an seinem Ausgang ein Signal erzeugt, das direkt proportional dem Betrag des Reflexionskoeffizienten ist.

13. Vorrichtung zum schnellen Testen nach einem der Ansprüche 11 und 12, gekennzeichnet durch die Tatsache, daß sie außerdem umfaßt:
   - eine Referenzleitung (lr) mit derselben Länge wie die erstgenannte Leitung (L), die mit dem Generator (G) über einen Richtungskoppler (800) verbunden ist,
   - einen reinen Widerstand, der mit dem zweiten Ende der Referenzleitung (lr) verbunden ist und
   - ein Niederfrequenzphasenmeßgerät (900, 900', 910, 910', 920, 930), das zwischen dem ersten Ende der erstgenannten Leitung (L) und dem ersten Ende der Referenzleitung (lr) zum Feststellen des Phasenwinkels des Reflexionskoeffizienten angeschlossen ist.

14. Vorrichtung zum schnellen Testen nach Anspruch 13, gekennzeichnet durch die Tatsache, daß das Niederfrequenzphasenmeßgerät umfaßt:
   - Detektoren (900, 900'), die die Gesamtwelle am Eingang jeder der beiden Leitungen detektieren,
   - Komparatoren (910. 910'), die die Ausgangspegel der Detektoren mit einem Schwellwert vergleichen,
   - ein exklusives Odergatter (920), dessen Eingänge jeweils mit den Ausgängen der Komparatoren

34

verbunden sind, und
- ein Tiefpaßfilter (930), das mit dem Ausgang des exklusiven Odergatters verbunden ist und das ein Signal proportional zur Phase der zu analysierenden Impedanz erzeugt.

15. Vorrichtung zum schnellen Testen nach einem der Ansprüche 11 bis 14, gekennzeichnet durch die Tatsache, daß der Generator (G) geeignet ist, die Leitung (L) mit einer periodischen, einfallenden Welle $v_i$ zu speisen, deren Periode sich in einem Bereich der Größenordnung von 1 µs bis 5 ns für eine Testdauer von ungefähr 1 s ändert.

16. Vorrichtung zum schnellen Testen nach einem der Ansprüche 11 bis 15 zur Analyse von Kondensatoren, gekennzeichnet durch die Tatsache, daß sie Vorrichtung umfaßt, die geeignet sind, die Stufen Gj des Betrags der Admittanz |Y| des Dipols auf der Basis der Beziehung

$$G_j = \frac{1}{R_c} \frac{1 - |\Gamma_j|}{1 + |\Gamma_j|}$$

bestimmt werden, in der
$R_c$    die charakteristische Impedanz der Leitung darstellt und
$|\Gamma_j|$    den Betrag des Reflexionskoeffizienten darstellt.

17. Vorrichtung zum schnellen Testen nach Anspruch 16 zur Analyse von Kondensatoren in der Form eines Netzwerks mit n parallelen Zweigen, die jeweils in Reihe einen Widerstand $R_j$ und eine Kapazität $C_j$ aufweisen, gekennzeichnet durch die Tatsache, daß sie aufweist
- Vorrichtungen, die geeignet sind, den Widerstand $R_j$ basierend auf der Beziehung $1/R_j = G_j - G_{j-1}$ zu bestimmen, wobei $G_j$ und $G_{j-1}$ zwei aufeinanderfolgende Stufen des Betrags der Admittanz |Y| darstellen, und
- Vorrichtungen, die geeignet sind die Kapazität $C_j$ auf der Basis der Beziehung

$$C_j = \frac{G_j - G_{j-1}}{\omega_j}$$

zu bestimmen, wobei $\omega_j$ die kritische Frequenz des betrachteten Zweigs darstellt.
zu bestimmen, wobei $\omega_j$ die kritische Frequenz des betrachteten Zweigs darstellt.

18. Vorrichtung zum schnellen Testen nach einem der Ansprüche 11 bis 17, gekennzeichnet durch die Tatsache, daß der Generator (G) einen Oszillator (100) mit variabler Frequenz mit automatischem Wechsel der Frequenzbänder umfaßt.

19. Vorrichtung zum schnellen Testen nach Anspruch 18, gekennzeichnet durch die Tatsache, daß sie einen Sägezahnsignalgenerator (200) umfaßt, daß der Schaltkreisabschluß des Oszillators (100) mit einer Diode mit variabler Kapazität ($D_v$), die durch ein Sägezahnsignal (200) polarisiert wird, das Wobbeln im Innern jedes Frequenzbandes sicherstellt, verbunden ist, wobei der Schaltkreisabschluß eine Mehrzahl von Drosselspulen (L301, L302, L303, L304) umfaßt, die jeweils eingeschaltet werden, um den Wechsel der Frequenzbänder sicherzustellen.

20. Vorrichtung zum schnellen Testen nach Anspruch 19, gekennzeichnet durch die Tatsache, daß der Sägezahnsignalgenerator (200) außerdem die Signale zum Wechseln der Frequenzbänder (400), die jeweils das Einschalten der Drosselspulen (L301, L302, L303, L304) des Abschlußschaltkreises des Oszillators sicherstellen, erzeugt.

21. Vorrichtung zum schnellen Testen nach Anspruch 20, gekennzeichnet durch die Tatsache, daß sie ein Schieberegister (430) mit seriellem Eingang und parallelen Ausgängen, das durch den Generator des Sägezahnsignals (200) gesteuert wird und am Ausgang die Signale zum Wechseln der Frequenzbänder erzeugt, umfaßt.

22. Vorrichtung zum Testen nach Anspruch 11, gekennzeichnet durch die Tatsache, daß sie außerdem Vorrichtung umfaßt, die geeignet sind, das den Phasenwinkel $\psi(\omega)$ des Reflexionskoeffizienten $\Gamma(\omega)$ auf der Basis folgender Beziehungen zu bestimmen:

$$\psi_M(\omega_M) = 2k\pi + 21/v\ \omega_M$$

und

$$\psi_m(\omega_m) = (2k+1)\pi + 21/v\ \omega_m,$$

in denen

$v$      die Fortpflanzungsgeschwindigkeit,

$\omega_M$      die einem Maximum entsprechende Frequenz und

$\omega_m$      die einem Minimum entsprechende Frequenz darstellt.

FIG_1

FIG_2

FIG_3

FIG_4

## FIG.5

## FIG.6

FIG. 7

FIG. 8

FIG. 9

FIG. 10

FIG_11

41

a) Réponse d'un condensateur équivalent à une branche $R_1C_1$ ( $R_1 = 180\,\Omega$, $C_1 = 100\,pf$ )
b) " " " " $R_2C_2$ ( $R_2 = 180\,\Omega$, $C_2 = 1nf$ )

FIG_12

EP 0 207 860 B1

Réponse d'un condensateur équivalent à deux branches $R_1C_1$, $R_2C_2$ ($R_1 = R_2 = 180\,\Omega$, $C_1 = 100\,pf$ $C_2 = 1\,nf$)

Courbe théorique

Courbe expérimentale

FIG. 13

EP 0 207 860 B1

Réponse expérimentale d'un condensateur
équivalent à deux branches $R_3C_3$ ; $R_4C_4$
( $R_3 = R_4 = 180\,\Omega$ , $C_3 = 1nF = 47pF$ )

FIG.14

EP 0 207 860 B1

FIG.15

a) Réponse expérimentale d'une ligne coaxiale de 1m

b {
---- Réponse théorique d'une ligne de 100m

—— Réponse expérimentale d'une ligne de 100m

a) Réponse à l'entrée de la ligne d'un circuit ouvert
b) Réponse d'une charge adaptée ( R = 50 Ω )

FIG.16

EP 0 207 860 B1

a) Réponse d'un condensateur equivalent à une
branche $R_1 C_1$ ( $R_1$ = 180 $\Omega$, $C_1$ = 47pF)
(Ligne de longueur 100m)

b) Réponse d'une charge adaptée ( $R$ = 50 $\Omega$ )

FIG. 17

FIG. 18

Reponse d'un condensateur équivalent à une branche $R_2C_2$ ($R_2 = 180\,\Omega$, $C_2 = 1nF$) Ligne de mesure de longueur 100m

FIG_19

EP 0 207 860 B1

ENTREE DE LA LIGNE →

**700** DETECTEUR LARGE BANDE $|V_t|^2$

**710** $\sqrt{}$ $|V_t|$

**720** $-$ $|V_t|-|V_i|$

**730** $\div$ $\dfrac{|V_t|-|V_i|}{|V_i|}$

**735** log $-kf^{\frac{1}{2}}+\log|\Gamma|$

**722** $\int$ $|V_i|$

**750** $+$ log $|\Gamma|$

**760** Antilog $|\Gamma|$

**200** VOBULATEUR F = aV $F/a$

**742** $\sqrt{}$ $bf^{\frac{1}{2}}$

**744** A $bAf^{\frac{1}{2}}=kf^{\frac{1}{2}}$

FIG. 20

FIG_21

EP 0 207 860 B1